# EUROPEAN PATENT APPLICATION

(11) **EP 3 396 864 A1**
(43) Date of publication of application: **31.10.2018**
(21) Application number: 16878171.4
(22) Date of filing: 08.11.2016
(51) Int. Cl.: H04B 5/02, H01L 23/12, H01L 23/50

(54) **CONTACTLESS COMMUNICATION MODULE**

(30) Priority: 21.12.2015 JP 2015248654; 06.05.2016 JP 2016093091
(71) Applicant: Hosiden Corporation, Yao-shi, Osaka 581-0071 (JP)
(72) Inventor: KONDO, Hayato, Yao-shi Osaka 581-0071 (JP)
(74) Representative: Beresford Crump LLP
(86) International application number: PCT/JP2016/083078
(87) International publication number: WO 2017/110273

(57) **Abstract**

[Problem] The invention provides a contactless communication module with improved communication accuracy.

[Configuration] A module M1 includes a base 100, an antenna 200, a semiconductor component 300, an internal connection 400, and an external connection 500. A partner communication device can be disposed at a short distance from, and on the Z-direction side relative to, the base 100. The antenna 200 is provided at the base 100, at a first height position such as to be able to contactlessly communicate with the partner communication device. The semiconductor component 300 is provided at the base 100, at the first height position or a second height position. The second height position is located on the Z'-direction side relative to the first height position. The internal connection 400 electrically connects the antenna 200 and the semiconductor component 300. The first portion 510 of the external connection 500 is provided at the base 100 and electrically connected to the semiconductor component 300. The second portion 520 of the external connection 500 protrudes out of the base 100.

## Description

### Technical field

The invention relates to a contactless communication module that performs communication in a contactless manner.

### Background Art

In contactless communication, the communication accuracy greatly depends on design of a communication electric circuit, such as a semiconductor chip and an antenna. In particular, it is more difficult to design the communication electric circuit as the communication speed of contactless communication increases. This is because such increase reveals the influence of components of a capacitor (C) and/or an inductance (L), such as the antenna, with respect to signal quality (signal integrity). For this reason, it has become more difficult to design the electric circuit for contactless communication and the electric circuit for main functions of an electronic device on the same circuit board of the electronic device. Consequently, it is considered that the electric circuit for contactless communication is modularized and that the module is mounted on a circuit board of the electronic device.

A conventional contactless communication module is disclosed in Patent Document 1. The contactless communication module includes a semiconductor chip, an antenna, an island, a plurality of lead terminals, and a plastic base. The antenna is configured to be able to contactlessly communicate with an antenna of a partner communication device. The semiconductor chip includes a device for causing the antenna to conduct contactless communication. The semiconductor chip is mounted on the island and connected to the antenna and ends of the lead terminals via wires. The plastic base of a rectangular shape has upper and lower faces and four side faces. The semiconductor chip, the antenna, and the ends of the lead terminal are sealed in the plastic base. The remaining portions of the lead terminals protrude from the side faces of the plastic base.

### Citation List

### Patent Literature

Patent Literature 1: Japanese Unexamined Patent Publication No. 2013-161905

### Summary of Invention

### Technical Problem to Be Solved by the Invention

The contactless communication module is adapted to conduct contactless communication between the antenna of the contactless communication module and the partner communication device as disposed above the upper face of the plastic base. The antenna of the contactless communication module is located on the same plane as the island and below the semiconductor chip on the island. In other words, the antenna is remote from the upper face (communication area) of the plastic base and also remote from the partner communication device, which degrades the communication accuracy of the contactless communication module.

The invention is devised in view of the above circumstances, and an object of the invention is to provide a contactless communication module that with improved communication accuracy.

### Solution to Problem

In order to solve the above problem, a contactless communication module according to an aspect of the invention includes a base made of an insulating resin, an antenna, a semiconductor component, an internal connection, and an external connection. A partner communication device can be disposed at a short distance from, and on one side of a first direction relative to, the base. The antenna is disposed at the base, at a first height position in the first direction such as to be able to contactlessly communicate with the partner communication device. The semiconductor component is adapted to cause the antenna to conduct contactless communication. The semiconductor component is disposed at the base, at the first height position or at a second height position on the other side of the first direction relative to the first height position. The internal connection electrically connects the antenna and the semiconductor component. The external connection includes a first portion and a second portion. The first portion is provided at the base and electrically connected to the semiconductor component. The second portion protrudes out of the base or being exposed to an outside of the base.

Such contactless communication module provides improved communication accuracy. This is because the antenna is disposed at the same height position as, or on one side of the first direction relative to, the semiconductor component. This arrangement decreases the distance in the first direction from the antenna to a partner communication device disposed at a short distance from, and on the one side of the first direction relative to, the base.

The antenna may be disposed at the first height position inside the base. The semiconductor component may be disposed at the first or second height position inside the base. The first portion of the external connection may be disposed inside the base. In the contactless communication module of this aspect, as the antenna and the semiconductor component are provided inside the base, they are protected by the base.

The internal connection may be a metal plate, a lead wire, a cable, or a conductive wire connecting the antenna and the semiconductor component and may be provided inside the base. In this case, the internal connection may be bent or curved such that the antenna is located at the first height position inside the base and that the semiconductor component is located at the second height position inside the base. In the contactless communication module of this aspect, it is easy to dispose the antenna at the first height position and the semiconductor component at the second position, simply by bending or curving the internal connection.

The antenna and the internal connection may be constituted by a single metal plate and provided inside the base. The internal connection may be bent or curved such that the antenna is located at the first height position inside the base and that the semiconductor component is located at the second height position inside the base. In the contactless communication module of this aspect, it is easy to dispose the antenna at the first height position and the semiconductor component at the second position, simply by bending or curving the internal connection.

The contactless communication module may further include a first circuit board. The first circuit board may be a flexible or rigid flexible circuit board including the internal connection. The internal connection may be provided inside the base. The internal connection may include a first portion provided with the antenna, a second portion electrically connected to the semiconductor component, and an intermediate portion between the first and second portions of the internal connection. The intermediate portion may be curved such that the antenna is located at the first height position inside the base and that the semiconductor component is located at the second height position inside the base. In the contactless communication module of this aspect, it is easy to dispose the antenna at the first height position and the semiconductor component at the second position, simply by curving the intermediate portion of the internal connection.

The first circuit board may further include the external connection. Such contactless communication module has a decreased number of components because the first circuit board includes the internal connection and the external connection.

The antenna and the internal connection may be constituted by a single metal plate extending in a second direction and may be provided inside the base. The second direction may be orthogonal to the first direction. The semiconductor component may be connected to the internal connection on the other side of the first direction relative to the internal connection. In the contactless communication module of this aspect, it is easy to dispose the antenna at the first height position and the semiconductor component at the second position, simply by connecting the semiconductor component to the internal connection on the other side of the first direction relative to the internal connection.

The contactless communication module may further include a second circuit board extending in a second direction orthogonal to the first direction. The second circuit board may include the internal connection provided inside the base. The internal connection may include a first face on one side of the first direction and a second face on the other side of the first direction. The antenna may be provided on the first face of the internal connection. The semiconductor component may be mounted on the second face of the internal connection, or alternatively connected to the internal connection on the other side of the first direction relative to the second face of the internal connection. In the contactless communication module of this aspect, it is easy to dispose the antenna at the first height position and the semiconductor component at the second position, simply by mounting the semiconductor component on the second face of the internal connection or connecting the semiconductor component to the internal connection on the other side of the first direction relative to the second face of the internal connection.

The second circuit board may further include the external connection. Such contactless communication module has a decreased number of components because the second circuit board includes the internal connection and the external connection.

The contactless communication module may further include a third circuit board. The third circuit board may be provided at least partially inside the base and may be a board on which the semiconductor component is mounted. The internal connection may be connected to the third circuit board and connected via the third circuit board to the semiconductor component.

The third circuit board may include the external connection.

The base may include an accommodation hole opening to the outside of the base. The internal connection may include a projection disposed in the accommodation hole. The first portion of the external connection may include a projection disposed in the accommodation hole. The semiconductor component may be accommodated in the accommodation hole, and electrically connected in the accommodation hole to the projection of the internal connection and the projection of the first portion of the external connection. The contactless communication module of this aspect offers improved versatility. This is because applications (i.e. for reception or transmission) and/or capabilities (i.e. communication speed and/or communication range) of the contactless communication module can be changed simply by selecting a semiconductor component suitable for the application, the capabilities, etc. of the contactless communication module, inserting the semiconductor component in an accommodation hole, and electrically connecting the semiconductor component to the projection of the internal connection and the projection of the first portion of the external connection.

The base may further include a first protector. The first protector may be a wall of the accommodation hole and surround the semiconductor component located in the accommodation hole. In the contactless communication module of this aspect, the semiconductor component in the accommodation hole is surrounded and protected by the first protector.

The base may have a first outer face located at the first height position. The antenna may be provided on the first outer face. The semiconductor component may be mounted on the first outer face.

The base may further include a second outer face located at the second height position. In this case, the semiconductor component may be mounted not on the first outer face, but on the second outer face. The base may further include a third outer face extending from the first outer face to the second outer face.

The antenna may be a metal film formed on the first outer face. The internal connection may be a metal film formed on at least the second and third outer faces such as to be continuous with the antenna. The semiconductor component may be directly connected to the internal connection on the second outer face. In the contactless communication module of this aspect, the antenna and the internal connection can be formed with ease on the base by printing, photolithography, or other method. It should be appreciated that the internal connection may alternatively be a metal film formed on at least the second and third outer faces such as to be connected to the antenna. In this case, the antenna may preferably be of a material other than a metal film.

The external connection may be made of a metal film formed at least on the second outer face of the base. The first portion of the external connection may be located on the second outer face. The semiconductor component may be directly connected to the internal connection and the first portion of the external connection on the second outer face. In the contactless communication module of this aspect, the external connection can be easily formed on the second outer face of the base by printing, photolithography, or other method. This aspect further facilitates mounting of the semiconductor component. This is because the semiconductor component is connectable to both the internal connection and the external connection on the second outer face.

The metal film may include a plated film.

The base may further include at least one second protector. The at least one second protector may extend in the first direction from the second outer face and may be disposed around the semiconductor component. In the contactless communication module of this aspect, the second protector disposed around the semiconductor component protects the semiconductor component.

The base may further include at least one third protector. The third protector may extend from the third outer face along the second outer face and may be disposed around the semiconductor component. In the contactless communication module of this aspect, the third protector disposed around the semiconductor component protects the semiconductor component.

The external connection may be a terminal, a pin, a lead wire, or a cable.

The contactless communication module according to any of the above aspects may further include a first conductor. The first conductor may be disposed on the other side of the first direction relative to the antenna. In the contactless communication module of this aspect, the first conductor shields signals leaked from the other side of the first direction relative to the first conductor, reducing the possibility that such leaked signals exert influence on the antenna.

The contactless communication module according to any of the above aspects may further include a second conductor. The second conductor may be disposed on one side of the first direction relative to the antenna and grounded. The second conductor may have an opening located on one side of the first direction relative to at least a part of the antenna. Such contactless communication module provides further improved communication accuracy.

### Brief Description of Drawings

Fig. 1A is a front, top, right side perspective view of a contactless communication module according to a first embodiment of the invention.
Fig. 1B is a front, top, right perspective view of the contactless communication module, with its base illustrated in broken lines to show the base as transparent.
Fig. 1C is a back, bottom, right side perspective view of the contactless communication module, with the base illustrated in broken lines to show the base as transparent.
Fig. 1D is a right side view of the contactless communication module, with the base illustrated in broken lines to show the base as transparent.
Fig. 2A is a front, top, right side perspective view of the contactless communication module, in a state before connecting its semiconductor component to an internal connection and an external connection of the contactless communication module.
Fig. 2B is a back, bottom, right side perspective view of the contactless communication module, in the state before connecting the semiconductor component to the internal connection and the external connection.
Fig. 3A is a schematic side view of a contactless communication module according to a second embodiment of the invention, with its base illustrated in broken lines to show the base as transparent.
Fig. 3B is a schematic side view of a contactless communication module according to a third embodiment of the invention, with its base illustrated in broken lines to show the base as transparent.
Fig. 4 is a schematic side view of a contactless communication module according to a fourth embodiment of the invention, with its base illustrated in broken lines to show the base as transparent.
Fig. 5A is a schematic side view of a contactless communication module according to a fifth embodiment of the invention, with its base illustrated in broken lines to show the base as transparent.
Fig. 5B is a schematic side view of a contactless communication module according to a sixth embodiment of the invention, with its base illustrated in broken lines to show the base as transparent.
Fig. 5C is a schematic side view of a contactless communication module according to a seventh embodiment of the invention, with its base illustrated in broken lines to show the base as transparent.
Fig. 6A is a schematic side view of a contactless communication module according to an eighth embodiment of the invention, with its base illustrated in broken lines to show the base as transparent.
Fig. 6B is a schematic side view of a contactless communication module according to a ninth embodiment of the invention, with its base illustrated in broken lines to show the base as transparent.
Fig. 7A is a front, top, right side perspective view of a contactless communication module according to a tenth embodiment of the invention.
Fig. 7B is a front, bottom, left side perspective view of the contactless communication module.
Fig. 8A is a front, top, left side perspective view of a base of the contactless communication module.
Fig. 8B is a sectional view the base of the contactless communication module, taken along a line 8B-8B in Fig. 8A, exaggerating metal complexes in the base.
Fig. 9A is a schematic sectional view of a variant of the contactless communication module according to the tenth embodiment of the invention.
Fig. 9B is a schematic sectional view of another variant of the contactless communication module according to the tenth embodiment of the invention.
Fig. 10A is a front, top, right side perspective view of a variant of the contactless communication module according to the first embodiment of the invention, with its base illustrated in broken lines to show the base as transparent.
Fig. 10B is a back, bottom, right side perspective view of the variant of the contactless communication module according to the first embodiment, with the base illustrated in broken lines to show the base as transparent.

### Modes for Carrying Out the Invention

The following describes first to ninth embodiments of the invention.

### First embodiment

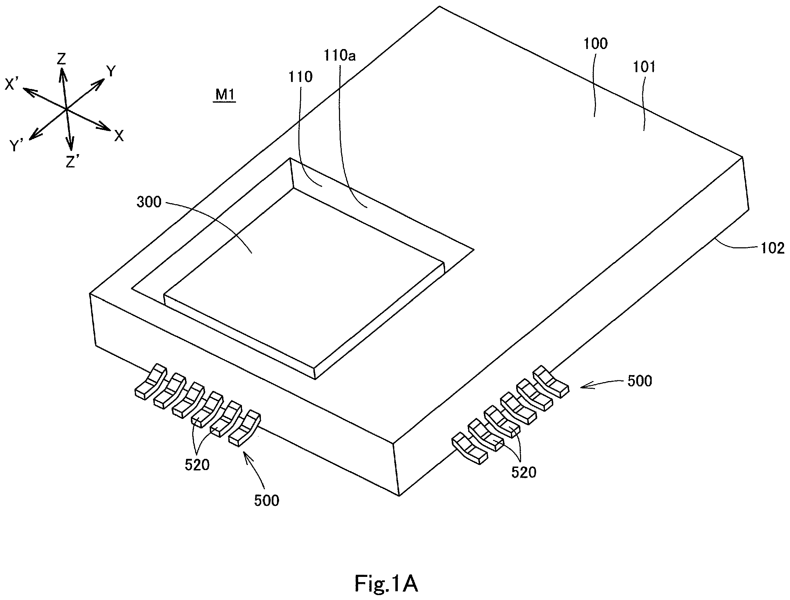

The following describes a contactless communication module M1 (also referred to hereinafter as module M1) according to a first embodiment of the invention, with reference to Figs. 1A to 2B. The module M1 is adapted to contactlessly communicate with a partner communication device (not shown). The Z-Z' direction indicated in Figs. 1A to 1D is the thickness direction of the module M1 and corresponds to the first direction in the claims. The Z direction corresponds to one side of the first direction and the Z' direction corresponds to the other side of the first direction. The Y-Y' direction indicated in Figs. 1A to 1D is the longitudinal direction of the module M1 and corresponds to the second direction in the claims. The Y-Y' direction is orthogonal to the Z-Z' direction. The X-X' direction indicated in Figs. 1A to 1C is the transverse direction of the module M1. The X-X' direction is orthogonal to the Z-Z' and Y-Y' directions.

The module M1 includes a base 100 (package), at least one antenna 200, at least one semiconductor component 300, at least one internal connection 400, and at least one external connection 500.

The base 100 is a solid block of an insulating resin or a case of an insulating resin. The base 100 may be a three-dimensional element of polygonal shape, a column, a sphere, a hemisphere, a three-dimensional element of arc-shaped section, or others.

The base 100 includes a first outer face 101 on the Z-direction side and a second outer face 102 on the Z'-direction side. The first outer face 101 includes a communication area. The partner communication device can be arranged at a short distance from, and on the Z-direction side relative to, the communication area of the base 100. For example, the second outer face 102 may be, but not limited to be, a face (mounting face) mountable on a circuit board of an electronic device (not shown) or a face (fixing face) fixable to a frame etc. of the electronic device.

If it is a solid block, the base 100 may further include at least one accommodation hole 110. The accommodation hole 110 may be a bottomed hole in the first outer face 101, opening in the Z direction and extending in the Z-Z' direction. Alternatively, the accommodation hole 110 may be a bottomed hole in the second outer face 102, opening in the Z' direction and extending in the Z-Z' direction. Still alternatively, the accommodation hole 110 may be a through-hole extending in the Z-Z' direction from the first outer face 101 to the second outer face 102 and opening in the Z and Z' directions. In Figs. 1A to 2B, the base 100 is a rectangular solid block made of an insulating resin, and it includes an accommodation hole 110 extending through the base 100, from the first outer face 101 to the second outer face 102. The accommodation hole 110 may be omitted.

The at least one antenna 200 is only required to be adapted for contactless communication with the partner communication device. For example, the antenna 200 may be adapted for contactless communication with the partner communication device via a communication scheme such as electromagnetic field coupling, magnetic field coupling, ultra-wide band (UWB), wireless LAN, and/or Bluetooth (registered trademark). The terms "to contactlessly communicate" and "contactless communication" as used herein refer to concepts including contactless proximity communication, ultra-wideband wireless communication, and narrowband wireless communication. Contactless proximity communication, which is broadband communication utilizing crosstalk of square-wave signals generating high-speed rise/fall times (high-frequency components), is adopted in electromagnetic field coupling, magnetic field coupling, and other schemes. Ultra-wide band wireless communication, which is wireless communication using a bandwidth of 500 MHz or over, is adopted in UWB etc. The narrowband wireless communication, which is wireless communication based on a modulated (narrowband) radio wave, is used in wireless LAN or Bluetooth (registered trademark). "To contactlessly communicate" and "contactless communication" as used herein may be any communication scheme via which contactless and wireless communication is conducted between an antenna of the invention and an antenna of a partner communication device.

If the antenna 200 is adapted for contactless communication via an electromagnetic field coupling scheme or a magnetic field coupling scheme, a communication distance in the Z-Z' direction from the antenna 200 to the partner communication device may range from zero to several millimeters. If the antenna 200 is adapted for contactless communication via a communication scheme such as wireless LAN and/or Bluetooth (registered trademark), the communication distance from the antenna 200 to the partner communication device may range from zero to several tens of meters. It should be noted that the communication distance from the antenna 200 to the partner communication device depends on the communication scheme adopted for the antenna 200. Even if the communication distance from the antenna 200 to the partner communication device is zero, the antenna 200 is not in contact with the corresponding antenna of the partner communication device.

If the antenna 200 is adapted for contactless communication via an electromagnetic field coupling scheme or a magnetic field coupling scheme, the antenna 200 is adapted to receive or transmit signals at bit rates over a wide range from a low speed of 1 Kbps to a high speed of 10 Gbps or larger. If signals are high-speed signals, the bit rate is about 1 Gbps or larger. If the antenna 200 is adapted for contactless communication via a communication scheme such as wireless LAN and/or Bluetooth (registered trademark), the antenna 200 is adapted to receive or transmits signals at a frequency of 2.4 GHz or 5 GHz. The speed of signals received or transmitted by the antenna 200 can be appropriately determined in accordance with the communication scheme adopted. The antenna 200 may be either a receiving antenna or a transmitting antenna.

The at least one antenna 200 may be constituted by a metal plate, a coil, a conductor, or the like. If the antenna 200 is adapted for contactless communication via an electromagnetic field coupling scheme, it is preferable to enlarge the outer size of at least a part of the antenna 200 in order to enlarge the area of the antenna 200 facing the corresponding antenna of the partner communication device. If adapted for contactless communication via a magnetic field coupling scheme, the antenna 200 may preferably be of a loop shape. The shape of the antenna 200 may be modified appropriately according to the communication scheme adopted.

The antenna 200 is disposed at a first height position in the Z-Z' direction inside the base 100 to allow contactless communication with the partner communication device. The antenna 200 is disposed on the Z'-direction side relative to the communication area of the base 100. If the base 100 is a solid block, the antenna 200 is sealed at the first height position inside the base 100-in other words, insert-molded inside the base 100 such as to be located at the first height position.

If the base 100 is a case, the antenna 200 is accommodated inside the base 100 such as to be located at the first height position. In this case, one of the following configurations 1) to 3) may be adopted. 1) The antenna 200 is held on the bottom, a wall, or other part of the base 100. 2) The antenna 200 is supported by a support provided inside the base 100. 3) The antenna 200 is supported by the at least one internal connection 400 inside the base 100.

The antenna 200 may be provided as a plurality of antennas 200. In this case, all the antennas 200 may be receiving antennas or transmitting antennas, or alternatively at least one of the antennas 200 may be a receiving antenna or antennas and the remainder is a transmitting antenna or antennas.

The at least one semiconductor component 300, which is a semiconductor element or elements, a semiconductor chip, or a semiconductor device packaged with an insulating resin, is adapted to cause the antenna 200 to conduct contactless communication (contactlessly receive or transmit signals). For example, if the antenna 200 is a receiving antenna, the semiconductor component 300 may be a comparator etc. with a hysteresis characteristic. If the antenna 200 is a transmitting antenna, the semiconductor component 300 may be a redriver etc. to control the rise time of signals to be transmitted through the antenna 200. The semiconductor component 300 may be appropriately configured according to the communication scheme adopted and according to whether the semiconductor component 300 is used for receiving or transmitting signals through the antenna 200. The semiconductor component 300 includes at least one first connection portion and at least one second connection portion. The first and second connection portions of the semiconductor component 300 are each an electrode, a pin, or the like.

The at least one semiconductor component 300 is disposed at the first height position or a second height position inside the base 100. More specifically, the end face on the Z'-direction side of the semiconductor component 300 is disposed at the first or second height position inside the base 100. The second height position is located on the Z'-direction side relative to the first height position. For example, the second height position may be located on the Z'-direction side relative to the first height position such that the antenna 200 at the first height position is located on the Z-direction side relative to the end face on the Z-direction side of the semiconductor component 300 at the second height position. If the base 100 is a solid block with no accommodation holes 110, the semiconductor component 300 is sealed at the first or second height position inside the base 100-in other words, insert-molded inside the base 100 such as to be located at the first or second height position.

If the base 100 is a case, the semiconductor component 300 is accommodated inside the base 100 such as to be located at the first or second height position. In this case, the semiconductor component 300 may have one of the following configurations 1) to 3). 1) The semiconductor component 300 is held on the bottom, a wall, or other part of the base 100. 2) The semiconductor component 300 is supported by a support provided inside the base 100. 3) The semiconductor component 300 is supported by at least one of the at least one internal connection 400 and the at least one external connection 500.

If the base 100 has the accommodation hole 110, the semiconductor component 300 is accommodated in the accommodation hole 110 of the base 100 such as to be located at the first or second height position. In this case, the semiconductor component 300 may be supported on the bottom of the accommodation hole 110 being a bottomed hole, or supported in midair inside the accommodation hole 110. In the latter case, the semiconductor component 300 may be supported in midair by a projection 420 of the at least one internal connection 400 and/or a projection 511 of the at least one external connection 500, and the projection 420 and/or the projection 511 protrude into the accommodation hole 110.

The semiconductor component 300 is surrounded by a first protector 110a, which is a loop-shaped annular wall of the accommodation hole 110. The first protector 110a protects the semiconductor component 300 inside the accommodation hole 110. The first protector 110a may preferably be larger in Z-Z' direction dimension than the semiconductor component 300 supported inside the accommodation hole 110. Alternatively, the first protector 110a may be substantially equal in Z-Z' direction dimension to, or smaller in Z-Z' direction than, the semiconductor component 300 supported inside the accommodation hole 110.

The at least one internal connection 400 is only required to be adapted to electrically connect the antenna 200 and the semiconductor component 300. The or each internal connection 400 may be constituted by a terminal, a pin, a lead wire, a cable, or a conductive wire, for example. The or each internal connection 400 may be connected to the antenna 200 directly, or indirectly via an electrically conductive intermediate member. Alternatively, the or each internal connection 400 may be integral with the antenna 200. For example, the antenna 200 and the internal connection(s) 400 may be constituted by a single metal plate, such as a lead frame. The or each internal connection 400 may be connected to the first connection portion of the semiconductor component 300 directly, or indirectly via an electrically conductive intermediate member. In the former case, the or each internal connection 400 may be of a shape conforming to the first connection portion of the semiconductor component 300. For example, the or each internal connection 400 may be an engagement hole or an engagement recess. The or each intermediate member is a terminal, a pin, a lead wire, a cable, a conductive wire, or the like.

The at least one internal connection 400 is disposed inside the base 100. If the base 100 is a solid block with no accommodation holes 110, the internal connection 400 is sealed inside the base 100-in other words, insert-molded inside the base 100. If the base 100 is a case, the internal connection 400 is accommodated inside the base 100. If the base 100 has the accommodation hole 110, the internal connection 400 includes an embedded portion 410 and the projection 420. The embedded portion 410 of the internal connection 400 is sealed inside the base 100-in other words, insert-molded inside the base 100. The projection 420 of the internal connection 400 protrudes into the accommodation hole 110, and is directly or indirectly connected to the first connection portion of the semiconductor component 300 as described above.

The at least one internal connection 400 may extend in a direction including a component of an orthogonal direction such that the antenna 200 is located away from the semiconductor component 300 in the direction including the component of the orthogonal direction. In this case, the antenna 200 is not located on the Z-direction side relative to the semiconductor component 300, but disposed away from the semiconductor component 300 in the direction including the component of the orthogonal direction, or alternatively disposed at a distance from the semiconductor component 300 in the orthogonal direction. The orthogonal direction is any direction orthogonal to the Z-Z' direction, which may be the Y-Y' direction, the X-X' direction, or a direction other than the Y-Y' and X-X' directions.

If the semiconductor component 300 is located at the second height position, the at least one internal connection 400 is bent or curved such that the antenna 200 is located at the first height position and that the semiconductor component 300 is located at the second height position.

The internal connection 400 may be a plurality of internal connections 400. The internal connections 400 may serve to electrically connect an antenna 200 and a semiconductor component 300. If a plurality of the antennas 200 and a plurality of the semiconductor components 300 are provided, each internal connection 400 may electrically connect one of the antennas 200 and a corresponding one of the semiconductor components 300, or more than one of the internal connections 400 may electrically connect an antenna 200 and a corresponding semiconductor component 300.

In Figs. 1A to 2B, an antenna 200 and a pair of internal connections 400 are constituted by a single metal plate. The embedded portions 410 of the internal connections 400 are integrally connected to the respective ends of the antenna 200. The antenna 200 and the embedded portions 410 of the internal connections 400 are sealed inside the base 100. The projections 420 of the internal connections 400 protrude into the accommodation hole 110 of the base 100 and are connected to the respective first connection portions of the semiconductor component 300. The internal connections 400 extends in a direction including a component of the Y-Y' direction (i.e. in a direction including a component of the orthogonal direction). The internal connections 400 are bent such that the antenna 200 is located at the first height position and that the semiconductor component 300 is located at the second height position.

In Figs. 1A to 2B, the semiconductor component 300 as facing upward (as shown) is connected to the internal connections 400. However, it is also possible to connect the semiconductor component 300 as facing downward (as shown) to the internal connections 400 (such as to be located on the Z'-direction side relative to the internal connection 400). This arrangement is also applicable to the case where the base 100 is a case or a solid block without any accommodation holes 110. In this case, the end face on the Z-direction side of the semiconductor component 300 is located at the second height position.

The at least one external connection 500 may be a terminal, a pin, a lead wire, or a cable, which serves to connect the module M1 to an external device. The or each external connection 500 is partly held by the base 100. The or each external connection 500 includes a first portion 510 and a second portion 520.

The first portion 510 may be connected to the second connection portion of the semiconductor component 300 directly, or indirectly via an electrically conductive intermediate member. In the former case, the first portion 510 may be of a shape conforming to the second connection portion of the semiconductor component 300. For example, the first portion 510 may be an engaging hole or an engaging recess. The intermediate member is a terminal, a pin, a lead wire, a cable, a conductive wire, or the like.

The first portion 510 is disposed inside the base 100. If the base 100 is a solid block with no accommodation holes 110, the first portion 510 is sealed inside the base 100-in other words, insert-molded inside the base 100. If the base 100 is a case, the first portion 510 is disposed inside the base 100. If the base 100 has the accommodation hole 110, the first portion 510 includes an embedded portion and the projection 511. The embedded portion of the first portion 510 is sealed inside the base 100-in other words, insert-molded inside the base 100. The projection 511 of the first portion 510 protrudes into the accommodation hole 110, and is directly or indirectly connected to the second connection portion of the semiconductor component 300 as described above.

The second portion 520 is disposed outside the base 100 and connectable to a circuit board or other component of the electronic device. The second portion 520 may preferably be exposed or protruded from the second outer face 102 or a side face of the base 100 to the outside of the base 100.

The external connection 500 may be provided as a plurality of external connections 500. The external connections 500 may be connected to a plurality of second connection portions of a semiconductor component 300. If a plurality of the semiconductor components 300 is provided, the first portion 510 of each external connection 500 may be connected to a second connection portion of a corresponding semiconductor component 300, or the first portions 510 of a plurality of the external connections 500 may be connected to second connection portions of a plurality of the semiconductor components 300. The external connections 500 may include an external connection or connections for signal transmission, for ground, and/or for a resister.

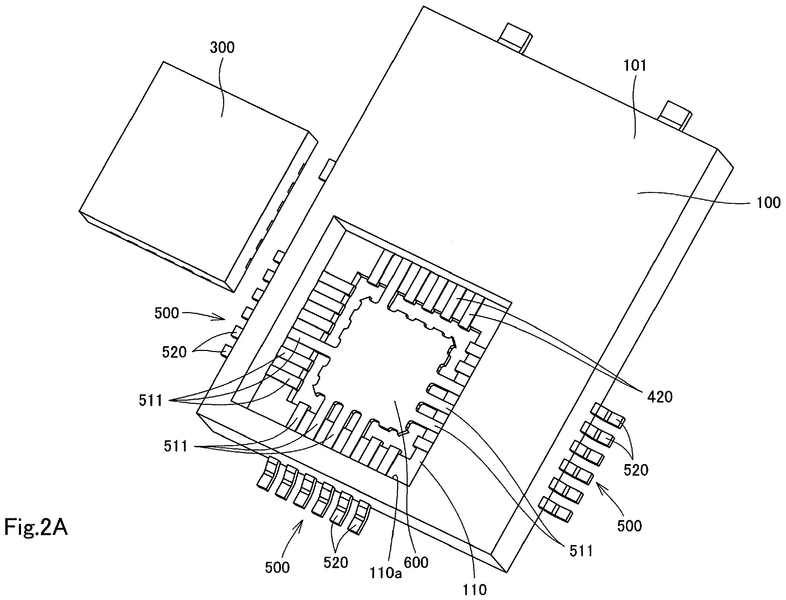

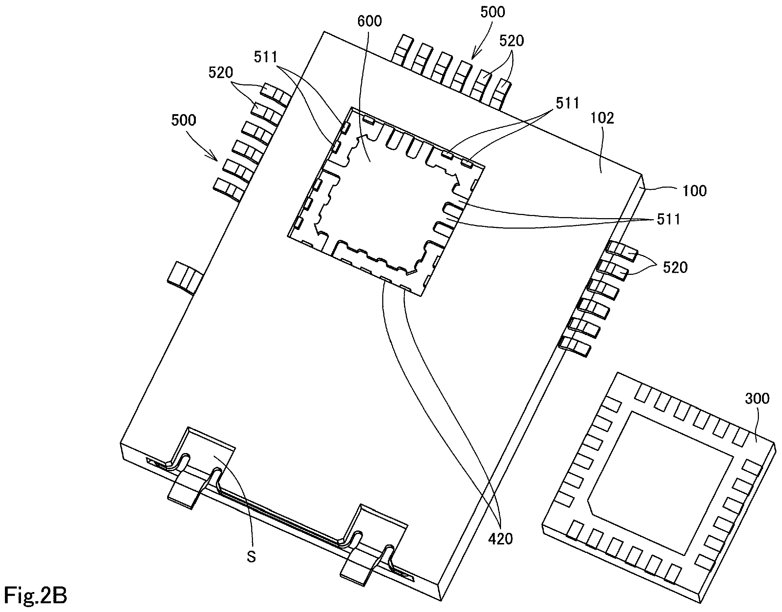

In Figs. 1A to 2B, a plurality of external connections 500 is provided, the embedded portions of the first portions 510 of the external connections 500 are sealed inside the base 100, and the projections 511 of the first portions 510 are connected, inside the accommodation hole 110, to the respective second connection portions of the single semiconductor component 300. The second portions 520 of the external connections 500 protrude out of the base 100, from the side faces on the Y'-, X-, and X'-direction sides of the base 100. Two of the external connections 500 are used for signal transmission, and the other external connections 500 are used for ground and for a resister.

If the base 100 is a case or a solid block having the at least one accommodation hole 110, the module M1 may further include at least one island 600. The at least one island 600 is supported in midair by the external connection 500, inside the base 100 being a case or in the accommodation hole 110 of the base 100. The island 600 supports in midair the semiconductor component 300 placed thereon. The semiconductor component 300 may be connected to the external connection 500 for ground via the island 600. The island 600 may be omitted.

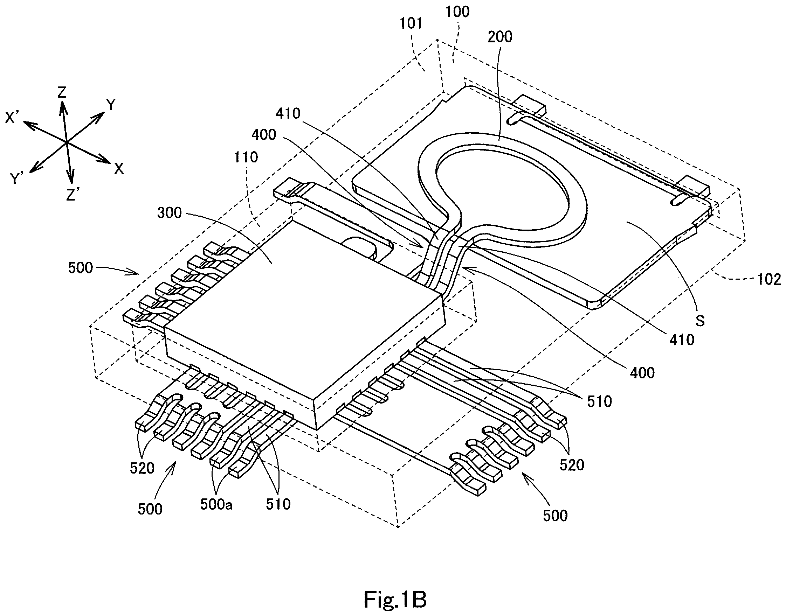

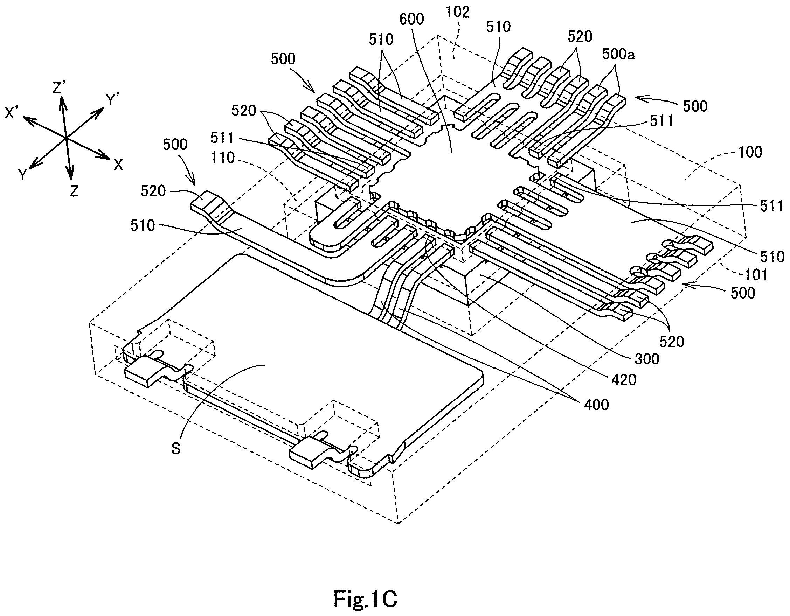

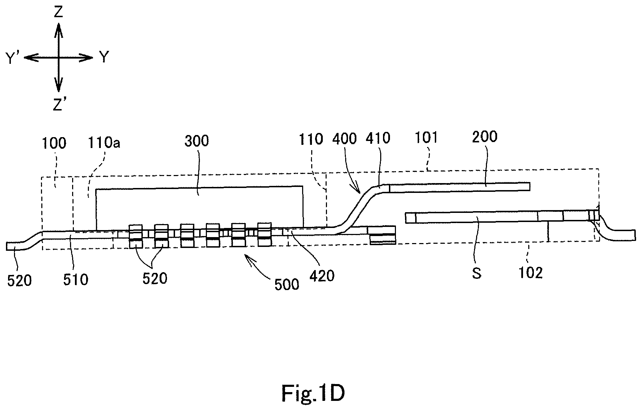

In Figs. 1 to 2B, an island 600 is supported in midair by the plurality of external connections 500, inside the accommodation hole 110 of the base 100. The semiconductor component 300 is supported in midair inside the accommodation hole 110, by the island 600, the projections 420 of the internal connections 400, and the projections 511 of the external connections 500.

The module M1 may further include a first conductor S. The first conductor S is constituted by a metal plate, a plate of plastic material having an outer face covered with evaporated metal, or the like. The first conductor S is disposed inside the base 100, on the Z'-direction side relative to the antenna 200. If the base 100 is a solid block, the first conductor S may be held in a holding hole in the base 100 or sealed (insert-molded) inside the base 100 such as to be located on the Z'-direction side relative to the antenna 200. Figs. 1 to 2B shows the former configuration. If the base 100 is a case, the first conductor S is accommodated ins the base 100 such as to be located on the Z'-direction side relative to the antenna 200. When the module M1 is mounted on the circuit board of the electronic device, the first conductor S is located between the antenna 200 and the circuit board of the electronic device. The first conductor S shields signals leaked from the circuit board of the electronic device (signals leaked from the other side of the first direction relative to the first conductor S), reducing the possibility that such leaked signals exert influence on the antenna 200. The first conductor S may be grounded. In this case, the first conductor S may be connected to the external connection 500 for grounding. The first conductor S may be omitted.

A method for manufacturing the module M1 will now be described in detail. In the method discussed here, the module M1 has the following configuration. The base 100 is a solid block with the accommodation hole 110. The antenna 200 and a pair of the internal connections 400 are constituted by a single metal plate. Alternatively, a pair of the internal connections 400 is constituted by a metal plate, and the embedded portions of the internal connections 400 are directly connected to the antenna 200.

First, the antenna 200 and the internal connections 400 are prepared, and the plurality of external connections 500 and the island 600 are also prepared. Then, a mold (not shown) is closed such that the antenna 200, the internal connections 400, the first portion 510 of the external connection 500, and the island 600 are disposed in a cavity of the mold. The step of closing the mold includes disposing the antenna 200 at a position in the cavity corresponding to the first height position, disposing in place the projections 420 of the internal connections 400 and the projections 511 of the first portions 510 of the external connections 500, accommodating the second portions 520 of the external connections 500 in the accommodation holes of the mold, and bringing protrusions of the mold into abutment with the projections 420 of the internal connections 400, the projections 511 of the first portions 510 of the external connections 500, and the island 600. Then, insulating resin is injected into the cavity to insert-mold the antenna 200, the embedded portions 410 of the internal connections 400, and the embedded portions of the first portions 510 of the external connections 500 in the insulating resin. The insulating resin hardens to form the base 100, and the accommodation hole 110 is formed in the base 100 conforming to the protrusions of the mold. As a result of such insert-molding, the antenna 200, the embedded portions 410 of the internal connections 400, and the embedded portions of the first portions 510 are sealed in the base 100, and the antenna 200 is disposed at the first height position inside the base 100. Also, the projections 420 of the internal connections 400, the projections 511 of the first portions 510 of the external connections 500, and the island 600 are disposed inside the accommodation hole 110, and the second portions 520 of the external connections 500 protrude out of the base 100. Then, the mold is opened to remove the antenna 200, the internal connections 400, the external connections 500, the island 600, and the base 100.

Then, the semiconductor component 300 is prepared. The semiconductor component 300 is accommodated into the accommodation hole 110 and placed onto the island 600 to be disposed at the first or second height position inside the base 100. Then, the first connection portions of the semiconductor component 300 are connected to the projections 420 of the internal connections 400 by soldering or other means, and the second connection portions of the semiconductor component 300 are connected to the projections 511 of the first portions 510 of the external connections 500 by soldering or other means.

In the above manufacturing method, the island 600 may be omitted. After accommodating the semiconductor component 300 in the accommodation hole 110, a potting process may be performed to fill the accommodation hole 110 with an insulating resin. In this case, the base 100 becomes a solid block with no accommodation holes 110. If the module M1 includes the first conductor S, it is preferable to insert the first conductor S into the holding hole of the base 100 before or after the step of accommodating the semiconductor component 300. Alternatively, the step of closing the mold may include disposing the first conductor S on the Z'-direction side relative to the antenna 200 inside the cavity, and the insert molding step may further include insert-molding the first conductor S in the insulating resin injected into the cavity. If the semiconductor component 300 is disposed at the second height position, the internal connections 400 to be prepared may be bent or curved in advance such that the antenna 200 and the semiconductor component 300 are located at the first height position and the second height position, respectively. The module M1 is thus manufactured.

The module M1 described above has technical features as follows. First, the of the module M1 improves communication accuracy for the following reasons. The antenna 200 is located at the first height position inside the base 100 and the semiconductor component 300 is located at the first or second height position, so that the antenna 200 is located near the communication area of the first outer face 101 of the base 100. This arrangement allows the antenna 200 to be located at a short distance in the Z-Z' direction to a partner communication device as disposed near and on the Z-direction side relative to the communication area. This is particularly true in a case where the antenna 200 at the first height position is located on the Z-direction side relative to the end face on the Z-direction side of the semiconductor component 300 at the second height position. In this case, the antenna 200 is located at a shorter distance in the Z-Z' direction to the partner communication device than the semiconductor component 300 is, further improving the communication accuracy of the module M1.

Second, it is possible to reduce the dimension in the Z-Z' direction of the module M1 for the following reasons. If the antenna 200 is spaced in the orthogonal direction from the semiconductor component 300, the module M1 has a reduced dimension in the Z-Z' direction of smaller compared with the case where the antenna 200 is aligned in the Z-Z' direction with the semiconductor component 300. The same applies to a case where the antenna 200 is located at the first height position and the semiconductor component 300 is located at the second height position. In this case, as the antenna 200 is spaced from the semiconductor component 300 in a direction orthogonal to the Z-Z' direction, the module M1 has a reduced dimension in the Z-Z' direction while improving communication accuracy of the module M1.

Third, the module M1 offers improved versatility if the base 100 is a case or a solid block including the accommodation hole 110. This is because applications (i.e. for reception or transmission) and/or capabilities (i.e. communication speed and/or communication range) of the module M1 can be changed simply by selecting a semiconductor component 300 suitable for the application, the capabilities, etc. of the module M1, inserting the semiconductor component 300 in a case or an accommodation hole 110, and electrically connecting the semiconductor component 300 to a projection 420 of an internal connection(s) 400 and a projection 511 of a first portion 510 of an external connection(s) 500.

Fourth, if the antenna 200 and the internal connection(s) 400 are constituted by a single metal plate, it is easy to arrange the antenna 200 and the semiconductor component 300 at the first height position and the second height position, respectively, for the following reasons. If the base 100 is a case or a solid block with no accommodation holes 110, the above arrangement of the antenna 200 and the semiconductor component 300 can be provided simply by bending or curving a part of the internal connection(s) 400, connecting such internal connection(s) 400 to the semiconductor component 300, and arranging the antenna 200, the internal connection(s) 400, and the semiconductor component 300 inside the base 100. If the base 100 is a solid block including the accommodation hole 110, the above arrangement of the antenna 200 and the semiconductor component 300 may be provided simply by bending or curving a part of the internal connection(s) 400, arranging the antenna 200 and internal connection(s) 400 inside the base 100, accommodating the semiconductor component 300 in the accommodation hole 110 of the base 100, connecting the semiconductor component 300 to the projection420 of the internal connection(s) 400. Also in a case where it is the internal connection(s) 400 that is constituted by a metal plate, the module M1 provides substantially the same technical features as those described in this paragraph.

Fifth, if the antenna 200 and the internal connection(s) 400 are constituted by a single metal plate, the module M1 has a decreased number of components.

### Second embodiment

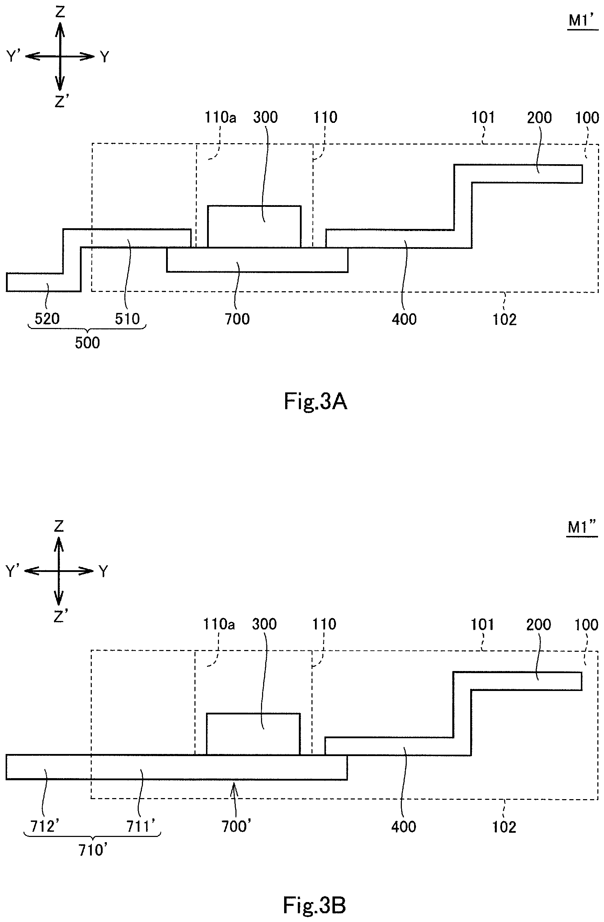

The following describes a contactless communication module M1' (also referred to hereinafter as a module M1') according to a second embodiment of the invention with reference to Fig. 3A. Fig. 3A also indicates the Z-Z' and Y-Y' directions in a similar manner to Fig. 1D.

The module M1' is different from the module M1 in that the module M1' does not include the island 600 but further includes a circuit board 700 (third circuit board). Otherwise the module M1' has substantially the same configuration as that of the module M1. The module M1' will now be described focusing on the differences from the module M1 and omitting overlapping descriptions.

The circuit board 700 is a rigid circuit board, a flexible circuit board, or a rigid flexible circuit board. The at least one semiconductor component 300 is mounted on the mounting face of the circuit board 700. The mounting face of the circuit board 700 may be either a Z-direction-side face or a Z'-direction-side face of the circuit board 700. The circuit board 700 is disposed inside the base 100 such that the end face on the Z'-direction side of the at least one semiconductor component 300 is located at the first or second height position inside the base 100.

If the base 100 is a solid block with no accommodation holes 110, the circuit board 700 is sealed inside the base 100-in other words, insert-molded inside the base 100-such that the end face on the Z'-direction side of the at least one semiconductor component 300 is located at the first or second height position.

If the base 100 is a case, the circuit board 700 is accommodated inside the base 100 such that the end face on the Z'-direction side of the at least one semiconductor component 300 is located at the first or second height position. In this case, one of the following configurations 1) to 3) may be adopted. 1) The circuit board 700 is held on the bottom, a wall, or other part of the base 100. 2) The circuit board 700 is supported by a support provided inside the base 100. 3) The circuit board 700 is supported by at least one of the internal connection(s) 400 and the external connection(s) 500 inside the base 100.

If the base 100 has the accommodation hole 110, one of the following configurations 1) to 3) may be adopted. 1) A part of the circuit board 700 (for example, an end portion in the Y, Y', X, and/or X' direction) is sealed inside the base 100, while a part of the mounting face of the circuit board 700 is exposed through the accommodation hole 110 to the outside of the base 100, such that the at least one semiconductor component 300 is located at the first or second height position. 2) The circuit board 700 is placed on the bottom of the accommodation hole 110 being a bottomed hole, while a part of the mounting face of the circuit board 700 is exposed through the accommodation hole 110 to the outside of the base 100, such that the at least one semiconductor component 300 is located at the first or second height position. 3) The circuit board 700 is supported in midair inside the base 100, by the internal connection(s) 400 and/or the external connection(s) 500, while a part of the mounting face of the circuit board 700 is exposed through the accommodation hole 110 to the outside of the base 100, such that the at least one semiconductor component 300 is located at the first or second height position. In Fig. 3A, configuration 1) is adopted.

The at least one internal connection 400 is connected to the circuit board 700 and connected via the circuit board 700 to the first connection portion of the semiconductor component 300. The first portion 510 of the at least one external connection 500 is connected to the circuit board 700 and connected via the circuit board 700 to the second connection portion of the semiconductor component 300. On the face of the circuit board 700 or inside the circuit board 700, there are provided at least one first conductive line (not shown) and at least one second conductive line (not shown). The at least one first conductive line connects the internal connection(s) 400 and the first connection portion(s) of the semiconductor component 300. The at least one second conductive line connects the first portion(s) 510 of the external connection 500 and the second connection portion(s) of the semiconductor component 300.

If there are provided a plurality of the internal connections 400 and a single semiconductor component 300 with a plurality of the first connection portions, a plurality of the first conductive lines is provided, each of which connects one of the internal connections 400 and a corresponding one of the first connection portions of the semiconductor component 300. If there are provided a plurality of the internal connections 400 and a plurality of the semiconductor components 300, and if each semiconductor component 300 includes a single first connection portion, the first connection portions of the semiconductor components 300 may be respectively connected to the internal connections 400 by a plurality of the first conductive lines. If there are provided a plurality of the internal connections 400 and a plurality of the semiconductor components 300, and if each semiconductor component 300 includes a plurality of first connection portions, the first connection portions of the semiconductor components 300 may also be respectively connected to the internal connections 400 by a plurality of the first conductive lines.

If there are provided a plurality of the external connections 500 and a single semiconductor component 300 with a plurality of the second connection portions, a plurality of second conductive lines is provided, each of which connects one of the first portions 510 of the external connections 500 and a corresponding one of the second connection portions of the semiconductor component 300. If there are provided a plurality of the external connections 500 and a plurality of the semiconductor components 300, and if each semiconductor component 300 includes a single second connection portion, the second connection portions of the semiconductor components 300 may be respectively connected to the external connections 500 by a plurality of the second conductive lines. If there are provided a plurality of the external connections 500 and a plurality of the semiconductor components 300, and if each semiconductor component 300 includes a plurality of second connection portions, the second connection portions of the semiconductor components 300 may be respectively connected to the external connections 500 by a plurality of the second conductive lines.

A method for manufacturing the module M1' will now be described in detail. In the method discussed here, the module M1' discussed here has the following configuration. The base 100 is a solid block with the accommodation hole 110. The antenna 200 and a pair of the internal connections 400 are constituted by a single metal plate. Alternatively, a pair of the internal connections 400 is constituted by a metal plate, and the embedded portions of the internal connections 400 are directly connected to the antenna 200.

First, the antenna 200 and the internal connections 400 are prepared as described above, and a plurality of the external connections 500 and the circuit board 700 are also prepared. The internal connections 400 and the external connections 500 are connected to the circuit board 700 by soldering or other means. Then, a mold (not shown) is closed such that the antenna 200, the internal connections 400, the first portions 510 of the external connections 500, and the circuit board 700 are disposed in a cavity of the mold. The step of closing the mold includes disposing the antenna 200 at a position in the cavity corresponding to the first height position, accommodating the second portions 520 of the external connections 500 in the accommodation holes of the mold, and bringing a protrusion of the mold into abutment with a part of the mounting face of the circuit board 700. Then, insulating resin is injected into the cavity to insert-mold the antenna 200, the internal connections 400, the circuit board 700, and the first portions 510 of the external connections 500 in the insulating resin. The insulating resin hardens to form the base 100, and the accommodation hole 110 is formed in the base 100 conforming to the protrusion of the mold. As a result of such insert-molding, the antenna 200, the internal connections 400, the circuit board 700, and the first portions 510 of the external connections 500 are sealed in the base 100, and the antenna 200 is disposed at the first height position inside the base 100. A part of the mounting face of the circuit board 700 is exposed through the accommodation hole 110 to the outside, and the second portions 520 of the external connections 500 protrudes out of the base 100. Then, the mold is opened to remove the antenna 200, the internal connections 400, the external connections 500, the circuit board 700, and the base 100.

Then, the semiconductor component 300 is prepared. The semiconductor component 300 is accommodated into the accommodation hole 110 and mounted onto the circuit board 700. Consequently, the semiconductor component 300 is disposed at the first or second height position inside the base 100, the first connection portions of the semiconductor component 300 is connected via the circuit board 700 to the internal connections 400, and the second connection portions of the semiconductor component 300 is connected via the circuit board 700 to the first portions 510 of the external connections 500. Then, a potting process may be performed to fill the accommodation hole 110 with an insulating resin, in a similar manner to the method for manufacturing the module M1. If the at least one semiconductor component 300 is disposed at the second height position, the internal connections 400 to be prepared may be bent or curved in advance such that the antenna 200 and the semiconductor component 300 are located at the first height position and the second height position, respectively. The module M1' is thus manufactured.

The module M1' described above has the first to fifth technical features of the module M1.

### Third embodiment

The following describes a contactless communication module M1" (also referred to hereinafter as a module M1") according to a third embodiment of the invention with reference to Fig. 3B. Fig. 3B indicates the Z-Z' and Y-Y' directions in a similar manner to Fig. 1D.

The module M1" differs from the module M1' in that the module M1" includes a circuit board 700' (third circuit board) in place of the external connection 500 and the circuit board 700. Otherwise the module M1" has substantially the same configuration as that of the module M1'. The module M1" will now be described focusing on the differences from the module M1' and omitting overlapping descriptions.

The circuit board 700' has substantially the same configuration as that of the circuit board 700, except that the end portion on the Y'-direction side of the circuit board 700' protrudes out of the base 100. The circuit board 700' includes an external connection 710'. The external connection 710' includes a first portion 711' and a second portion 712'. The first portion 711' is a part of the circuit board 700' that is located inside the base 100. The second portion 712' is an end portion of the circuit board 700' that protrudes out of the base 100. On the face of the circuit board 700' or inside the circuit board 700', there is provided at least one first conductive line (not shown). The at least one first conductive line of the circuit board 700' has substantially the same configuration as that of the first conductive line of the circuit board 700. On the face of the external connection 710' or inside the external connection 710', there is further provided at least one second conductive line (not shown). The at least one second conductive line of the external connection 710' has substantially the same configuration as that of the second conductive line of the circuit board 700 except for the following differences. The at least one second conductive line of the external connection 710' is connected to the second connection portion of the semiconductor component 300 and includes an end portion located outside the base 100. This end portion of the at least one second conductive line is provided on or in the second portion 712'. The second portion 712' may be connected to the circuit board of the electronic device directly, or indirectly via a cable or other means like. In the latter case, the first outer face 101 of the base 100 may be fixed to the casing of the electronic device with an adhesive or other means.

A method for manufacturing the module M1" will now be described in detail. The antenna 200 and a pair of the internal connections 400 are prepared in a similar manner to the method for manufacturing the module M1'. The circuit board 700' is also prepared. The internal connections 400 are connected to the circuit board 700' by soldering or other means. Then, a mold (not shown) is closed such that the antenna 200, the internal connections 400, and the circuit board 700' excluding the second portion 712' are disposed in a cavity of the mold. The step of closing the mold includes disposing the antenna 200 at a position in the cavity corresponding to the first height position, accommodating the second portion 712' of the circuit board 700' in the accommodation hole of the mold, and bringing a protrusion of the mold into abutment with a part of the mounting face of the circuit board 700'. Then, insulating resin is injected into the cavity to insert-mold the antenna 200, the internal connections 400, and the circuit board 700' excluding the second portion 712' in the insulating resin. The insulating resin hardens to form the base 100, and the accommodation hole 110 is formed in the base 100 conforming to the protrusion of the mold. As a result of such insert-molding, the antenna 200, the internal connections 400, and the circuit board 700' excluding the second portion 712' are sealed inside the base 100, and the antenna 200 is disposed at the first height position inside the base 100. A part of the mounting face of the circuit board 700 is exposed through the accommodation hole 110 to the outside, and the second portion 712' of the circuit board 700' protrudes out of the base 100. Then, the mold is opened to remove the antenna 200, the internal connection 400, the circuit board 700', and the base 100.

In the method for manufacturing the module M1", the step of mounting the semiconductor component 300 may preferably include mounting the semiconductor component 300 on the circuit board 700', instead of mounting it on the circuit board 700. Alternatively, the method for manufacturing the module M1" may include the following steps 1) and/or 2) similarly to the method for manufacturing the module M1: 1) A potting process may be performed to fill the accommodation hole 110 with an insulating resin. 2) If the module M1" includes the first conductor S, the first conductor S may be held by the base 100. The module M1" is thus manufactured.

The module M1" described above has the first to fifth technical features of the module M1. Additionally, the module M1" has a further reduced number of components because the circuit board 700' includes the external connection 710'.

### Fourth embodiment

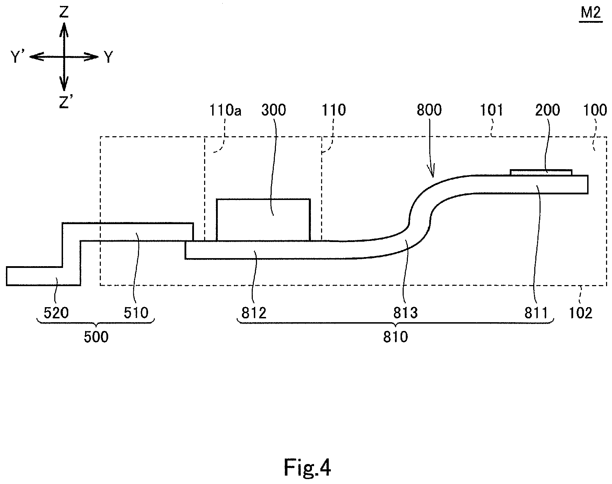

The following describes a contactless communication module M2 (also referred to hereinafter as a module M2) according to a fourth embodiment of the invention with reference to Fig. 4. Fig. 4 also indicates the Z-Z' and Y-Y' directions in a similar manner to Fig. 1D.

The module M2 is different from the module M1 in that the module M2 does not include the island 600 but includes a circuit board 800 (first circuit board) in place of the internal connection 400. Otherwise the module M2 has substantially the same configuration as that of the module M1. The module M2 will now be described focusing on the differences from the module M1 and omitting overlapping descriptions.

The circuit board 800 is a flexible circuit board or a rigid flexible circuit board. The circuit board 800 includes an internal connection 810. The internal connection 810 includes a first portion 811, a second portion 812, and an intermediate portion 813. The at least one antenna 200 is provided on the first portion 811. The antenna 200 is constituted by a metal plate, a coil, a conductor, etc. The second portion 812 is electrically connected to the semiconductor component 300. Specifically, the semiconductor component 300 is mounted on the second portion 812. The mounting face of the second portion 812 may be either the Z-direction-side face or the Z'-direction-side face of the second portion 812. On or inside the internal connection 810 there is provided at least one first conductive line (not shown). The at least one first conductive line of the internal connection 810 has substantially the same configuration as that of the first conductive line of the circuit board 700, except that the at least one first conductive line of the internal connection 810 connects the antenna 200 and the first connection portion of the semiconductor component 300.

The second portion 812 of the circuit board 800 is connected to the first portion 510 of the at least one external connection 500. That is, the at least one external connection 500 is connected via the circuit board 800 to the second connection portion of the semiconductor component 300. On the face of the circuit board 800 or inside the circuit board 800, there is provided at least one second conductive line (not shown). The at least one second conductive line of the circuit board 800 has substantially the same configuration as that of the second conductive line of the circuit board 700. The intermediate portion 813 is curved such that the at least one antenna 200 is located at the first height position and that the end face on the Z'-direction side of the at least one semiconductor component 300 is located at the second height position.

If the base 100 is a solid block with no accommodation holes 110, the circuit board 800 is sealed inside the base 100-in other words, insert-molded inside the base 100-such that the at least one antenna 200 is located at the first height position and that the end face on the Z'-direction side of the at least one semiconductor component 300 is located at the second height position.

If the base 100 is a case, the circuit board 800 is accommodated inside the base 100 such that the at least one antenna 200 is located at the first height position and such that the end face on the Z'-direction side of the at least one semiconductor component 300 is located at the second height position. In this case, one of the following configurations 1) to 3) may be adopted. 1) The first portion 811 of the circuit board 800 is held on the wall or other part of the base 100, and the second portion 812 of the circuit board 800 is held on the bottom, a wall, or other part of the base 100. 2) The first portion 811 of the circuit board 800 is supported by a first support inside the base 100, and the second portion 812 of the circuit board 800 is supported by a second support inside the base 100. 3) The first portion 811 of the circuit board 800 is held on a wall of the base 100, the first support, or other part, and the second portion 812 of the circuit board 800 is supported by the at least one external connection 500 inside the base 100.

If the base 100 has the accommodation hole 110, the circuit board 800 is sealed inside the base 100-in other words, insert-molded inside the base 100-such that the at least one antenna 200 is located at the first height position and that the end face on the Z'-direction side of the at least one semiconductor component 300 is located at the second height position. In this case, one of the following configurations 1) to 3) may be adopted. 1) A part of the mounting face of the second portion 812 of the circuit board 800 constitutes the bottom of the accommodation hole 110. 2) The second portion 812 of the circuit board 800 is placed on the bottom of the accommodation hole 110 being a bottomed hole, and a part of the mounting face of the second portion 812 is exposed through the accommodation hole 110 to the outside of the base 100. 3) The second portion 812 of the circuit board 800 is supported in midair inside the accommodation hole 110, by the at least one external connection 500, and a part of the mounting face of the second portion 812 is exposed through the accommodation hole 110 to the outside of the base 100. In Fig. 4, configuration 1) is adopted.

A method for manufacturing the module M2 will now be described in detail. In the method discussed here, the base 100 is a solid block with the accommodation hole 110. First, the circuit board 800 is prepared, on the first portion 811 of which the antenna 200 is provided. A plurality of the external connections 500 are also prepared. The external connections 500 are connected to the second portion 812 of the circuit board 800 by soldering or other means.

Then, a mold (not shown) is closed such that the antenna 200, the circuit board 800, and the first portions 510 of the external connections 500 are disposed in a cavity of the mold. The step of closing the mold includes disposing the antenna 200 at a position in the cavity corresponding to the first height position, accommodating the second portions 520 of the external connections 500 in the accommodation holes of the mold, and bringing a protrusion of the mold into abutment with a part of the mounting face of the second portion 812 of the circuit board 800. Then, insulating resin is injected into the cavity to insert-mold the antenna 200, the circuit board 800, and the first portions 510 of the external connections 500 in the insulating resin. The insulating resin hardens to form the base 100, and the accommodation hole 110 is formed in the base 100 conforming to the protrusion of the mold. As a result of such insert-molding, the antenna 200, the circuit board 800, and the first portions 510 of the external connections 500 are sealed in the base 100, and the antenna 200 is disposed at the first height position inside the base 100. The part of the mounting face of the second portion 812 of the circuit board 800 is exposed through the accommodation hole 110 to the outside, and the second portions 520 of the external connections 500 protrude out of the base 100. Then, the mold is opened to remove the antenna 200, the circuit board 800, the external connections 500, and the base 100.

Then, the semiconductor component 300 is prepared. The semiconductor component 300 is accommodated in the accommodation hole 110 and mounted on the second portion 812 of the circuit board 800. Consequently, the semiconductor component 300 is disposed at the second height position inside the base 100, the first connection portions of the semiconductor component 300 are connected to the first conductive lines of the internal connection 810 of the circuit board 800, and the second connection portions of the semiconductor component 300 is connected to the first portions 510 of the external connections 500 through the second conductive lines of the circuit board 800. Then, a potting process may be performed to fill the accommodation hole 110 with an insulating resin. If the module M2 includes the first conductor S, the first conductor S may be held by the base 100 similarly to the method for manufacturing the module M1. The module M2 is thus manufactured.

The module M2 described above has the first to fourth technical features of the module M1.

### Fifth embodiment

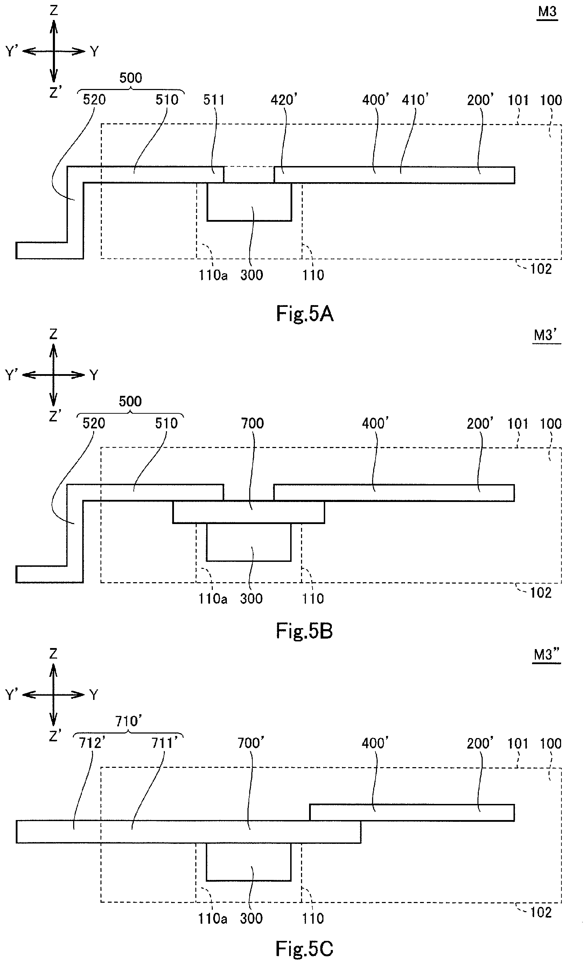

The following describes a contactless communication module M3 (also referred to hereinafter as a module M3) according to a fifth embodiment of the invention with reference to Fig. 5A. Fig. 5A also indicates the Z-Z' and Y-Y' directions in a similar manner to Fig. 1D.

The module M3 is different from the module M1 in that the module M3 includes at least one antenna 200' and at least one internal connection 400' in place of the at least one antenna 200 and the at least one internal connection 400. Otherwise the module M3 has substantially the same configuration as that of the module M1. The module M3 will now be described focusing on the differences from the module M1 and omitting overlapping descriptions.

The at least one antenna 200' and the at least one internal connection 400' are constituted by a single metal plate (e.g., a lead frame). In Fig. 5A, a pair of internal connections 400' (only one of them is shown) is integrally connected to the respective ends of the antenna 200'.

The at least one antenna 200' and the at least one internal connection 400' are disposed inside the base 100, in a similar manner to the antenna 200 and the internal connection 400 of the module M1. The at least one antenna 200' is located at the first height position. The at least one internal connection 400' extends in the Y-Y' direction, and accordingly the antenna 200 is located away from the semiconductor component 300 in the Y-Y' direction (a direction orthogonal to the Z-Z' direction).

The at least one semiconductor component 300 is located inside the base 100 at the second height position, which is on the Z'-direction side relative to the internal connection(s) 400'. In this case, the end face on the Z-direction side of the semiconductor component 300 is located at the second height position. The first connection portion(s) of the semiconductor component 300 is connected to the internal connection(s) 400' directly, or indirectly via an intermediate member(s). The or each intermediate member is a lead wire, a cable, a conductive wire, or the like.

If the base 100 has the accommodation hole 110, the accommodation hole 110 may be a bottomed hole in the second outer face 102, opening in the Z' direction. Alternatively, the accommodation hole 110 may be a through-hole extending from the first outer face 101 to the second outer face 102 and opening in the Z and Z' directions. In either case, the at least one semiconductor component 300 is located on the Z'-direction side relative to the at least one internal connection 400' inside the accommodation hole 110 and connected to the projection 420' of the at least one internal connection 400' directly or indirectly via an intermediate member. In this case, the or each internal connection 400' includes an embedded portion 410' and a projection 420'. The or each embedded portion 410' is sealed inside the base 100. The or each projection 420' protrudes into the accommodation hole 110 and is connected to the first connection portion of the semiconductor component 300 as described above.

The module M3 may further include the island 600 and/or the first conductor S. The module M3 is manufactured in a similar manner to the module M1. The module M3 has the first to fifth technical features of the module M1.

### Sixth embodiment

The following describes a contactless communication module M3' (also referred to hereinafter as a module M3') according to a sixth embodiment of the invention with reference to Fig. 5B. Fig. 5B also indicates the Z-Z' and Y-Y' directions in a similar manner to Fig. 1D.

The module M3' is different from the module M3 in that the module M3' does not include the island 600 but further includes a circuit board 700 (third circuit board). Otherwise the module M3' has substantially the same configuration as that of the module M3. The module M3' will now be described focusing on the differences from the module M3 and omitting overlapping descriptions.

The circuit board 700 of the module M3' has substantially the same configuration as the circuit board 700 of the module M1'. The mounting face of the circuit board 700 of the module M3' is the Z'-direction-side face of the circuit board 700. The at least one semiconductor component 300 is mounted on the mounting face of the circuit board 700. The internal connection(s) 400' is connected to the Z-direction-side face (the face opposite to the mounting face) of the circuit board 700 and connected via the circuit board 700 to the first connection portion of the semiconductor component 300. As such, the semiconductor component 300 is connected to the internal connection(s) 400' via the circuit board 700, on the Z'-direction side relative to the internal connection(s) 400', to be located at the second height position of the base 100.

The module M3' may further include the first conductor S. The module M3' is manufactured in substantially the same manner as the module M1'. The module M3' has the first to fifth technical features of module M1.

### Seventh embodiment

The following describes a contactless communication module M3" (also referred to hereinafter as a module M3") according to the seventh embodiment of the invention with reference to Fig. 5C. Fig. 5C also indicates the Z-Z' and Y-Y' directions in a similar manner to in Fig. 1D.

The module M3" differs from the module M3' in that the module M3" includes a circuit board 700' (third circuit board) in place of the external connection 500 and the circuit board 700. Otherwise the module M3" has substantially the same configuration as that of the module M3'. The module M3" will now be described focusing on the differences from the module M3' and omitting overlapping descriptions.

The circuit board 700' of the module M3" has substantially the same configuration as the circuit board 700' of the module M1". The circuit board 700' includes an external connection 710'. The external connection 710' includes a first portion 711' and a second portion 712'. If the second portion 712' is connected to the circuit board of the electronic device indirectly via a cable or other means, the first outer face 101 of the base 100 may be fixed to the casing of the electronic device with an adhesive or other means. The mounting face of the circuit board 700' of the module M3" is the Z'-direction-side face of the circuit board 700'. The at least one semiconductor component 300 is mounted on the mounting face of the circuit board 700'. The at least one internal connection 400' is connected to the Z-direction-side face (the face opposite to the mounting face) of the circuit board 700' and connected via the circuit board 700' to the first connection portion(s) of the semiconductor component 300. As such, the semiconductor component 300 is connected to the internal connection(s) 400' via the circuit board 700, on the Z'-direction side relative to the internal connection(s) 400', to be located at the second height position of the base 100.

The module M3" may further include the first conductor S. The module M3" is manufactured in substantially the same manner as the module M1". The module M3" has the first to fifth technical features of the module M1. Additionally, the module M3" has a further reduced number of components because the circuit board 700' includes the external connection 710'.

### Eighth embodiment

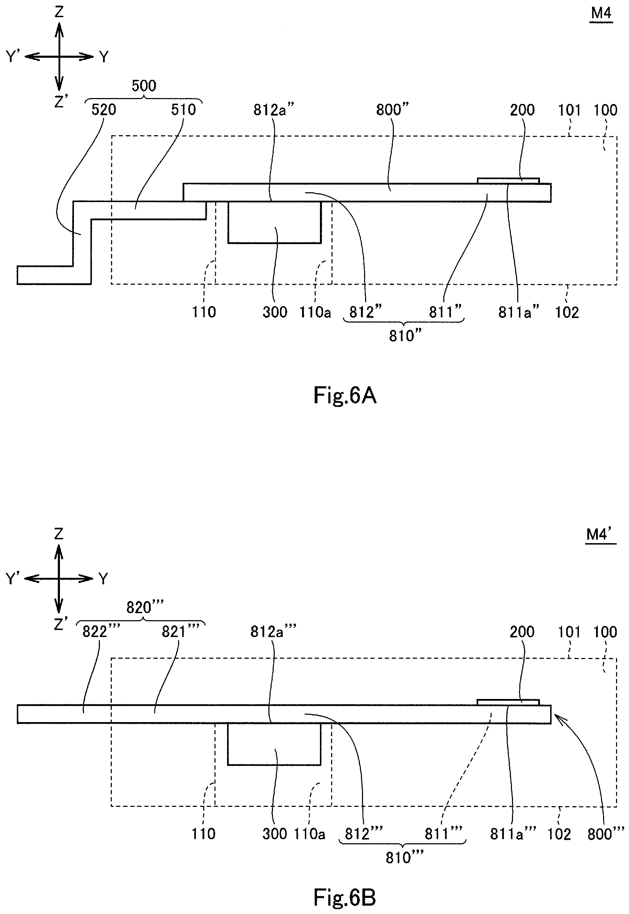

The following describes a contactless communication module M4 (also referred to hereinafter as a module M4) according to an eighth embodiment of the invention with reference to Fig. 6A. Fig. 6A also indicates the Z-Z' and Y-Y' directions are illustrated as in Fig. 1D.

The module M4 is different from the module M2 in that the module M4 includes a circuit board 800" (second circuit board) in place of the circuit board 800. Otherwise the module M4 has substantially the same configuration as that of the module M2. The module M4 will now be described focusing on the differences from the module M2 and omitting overlapping descriptions.

The circuit board 800" of the module M4 is a rigid circuit board, a flexible circuit board, or a rigid flexible circuit board. The circuit board 800" of the module M4 has substantially the same configuration as the circuit board 800 of the module M2, except that the circuit board 800" extends in the Y-Y' direction. The circuit board 800" is disposed inside the base 100 in substantially the same manner to the circuit board 800 of the module M2. The circuit board 800" includes an internal connection 810". The internal connection 810" includes a first portion 811" and a second portion 812". The first portion 811" has a Z-direction-side face 811 a" (the first face in the claims), on which the at least one antenna 200 is provided. The at least one antenna 200 is located at the first height position inside the base 100.

The mounting face 812a" (the second face in the claims) of the circuit board 800" is the Z'-direction-side face of the second portion 812" of the internal connection 810" of the circuit board 800". The at least one semiconductor component 300 is mounted on the mounting face 812a" of the second portion 812" of the internal connection 810". Alternatively, the at least one semiconductor component 300 may be disposed on the Z'-direction side relative to the mounting face 812a" of the second portion 812" of the internal connection 810" and connected to the circuit board 800" indirectly via an intermediate member(s). The or each intermediate member is a terminal, a pin, a lead wire, a cable, a conductive wire, or the like. As such, the at least one semiconductor component 300 is connected to the internal connection 810", on the Z'-direction side relative to the internal connection 810", to be located at the second height position inside the base 100. In this case, the end face on the Z-direction side of the at least one semiconductor component 300 is located at the second height position.

As described above, since the circuit board 800" extends in the Y-Y' direction, the antenna 200 is disposed away from the semiconductor component 300 in the Y-Y' direction (the direction orthogonal to the Z-Z' direction). The at least one external connection 500 of the module M4 has substantially the same configuration as that of the external connection 500 of the module M2.

If the base 100 has the accommodation hole 110, the accommodation hole 110 may be a bottomed hole in the second outer face 102, opening in the Z' direction, or may alternatively be a through-hole extending from the first outer face 101 to the second outer face 102 and opening in the Z-Z' direction. In either case, the at least one semiconductor component 300 is connected to the second portion 812" on the Z'-direction side relative to the second portion 812" of the internal connection 810" inside the accommodation hole 110.

The module M4 may further include the first conductor S. The module M4 is manufactured in substantially the same manner as the module M2. The module M4 has substantially the same technical features as module M2.

### Ninth embodiment

The following describes a contactless communication module M4' (also referred to hereinafter as a module M4') according to a ninth embodiment of the invention with reference to Fig. 6B. Fig. 6B also indicates the Z-Z' and Y-Y' directions in a similar manner to Fig. 1D.

The module M4' differs from the module M4 in that the module M4' includes a circuit board 800"' (second circuit board) in place of the external connection 500 and the circuit board 800". Otherwise the module M4' has substantially the same configuration as that of the module M4. The module M4' will now be described focusing on the differences from the module M4 and omitting overlapping descriptions.

The circuit board 800"' of module M4' is a rigid circuit board, a flexible circuit board, or a rigid flexible circuit board. The circuit board 800"' of the module M4' has substantially the same configuration as the circuit board 800' of the module M2"', except that the circuit board 800"' extends in the Y-Y' direction. The circuit board 800"' includes an internal connection 810"' and an external connection 820"'. In the circuit board 800"', the internal connection 810"' and the external connection 820"' excluding the second portion 822' are disposed inside the base 100. The internal connection 810"' includes a first portion 811"' and a second portion 812"'. The at least one antenna 200 is provided on the Z-direction-side face 811a"' of the first portion 811"' (the first face in the claims). The at least one antenna 200 is located at the first height position inside the base 100.

A mounting face 812a"' of the circuit board 800"' (the second face of the claims) is the Z'-direction-side face of the second portion 812"' of the internal connection 810"' of the circuit board 800"'. The at least one semiconductor component 300 is mounted on the mounting face 812a"' of the second portion 812"' of the internal connection 810"'. Alternatively, the at least one semiconductor component 300 may be disposed on the Z'-direction side relative to the mounting face 812a"' of the second portion 812"' of the internal connection 810"' and connected to the circuit board 800"' indirectly via an intermediate member(s). The or each intermediate member is a terminal, a pin, a lead wire, a cable, a conductive wire, or the like. As such, the at least one semiconductor component 300 is connected to the internal connection 810", on the Z'-direction side relative to the internal connection 810"', to be located at the second height position inside the base 100.

As the circuit board 800"' extends in the Y-Y' direction as described above, the antenna 200 is disposed away from the semiconductor component 300 in the Y-Y' direction (a direction orthogonal to the Z-Z' direction).

The external connection 820"' of the circuit board 800"' of the module M4' has substantially the same configuration as that of the external connection 820' of the circuit board 800' of the module M2"'. The external connection 820"' includes a first portion 821"' and a second portion 822"'. The first portion 821"' is a part of the external connection 820"' that is located inside the base 100. The second portion 822"' is a part of the external connection 820' that protrudes out of the base 100.

If the base 100 has the accommodation hole 110, the accommodation hole 110 may be a bottomed hole in the second outer face 102, opening in the Z' direction. Alternatively, the accommodation hole 110 may be a through-hole extending from the first outer face 101 to the second outer face 102 and opening in the Z-Z' direction. In either case, the at least one semiconductor component 300 is connected to the second portion 812"' on the Z'-direction side relative to the second portion 812"' of the internal connection 810"' in the accommodation hole 110.

The module M4' may further include the first conductor S. The module M4' is manufactured in substantially the same manner as the module M2"'. The module M4' has technical features similar to module M2"'.

### Tenth embodiment

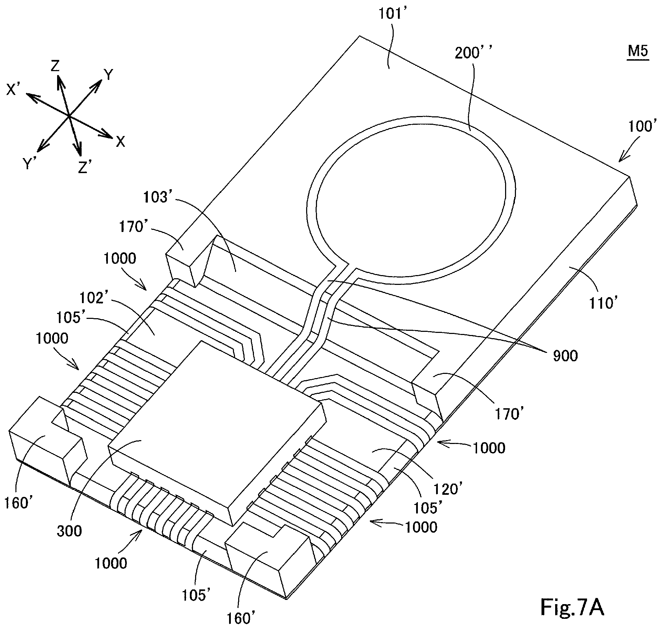

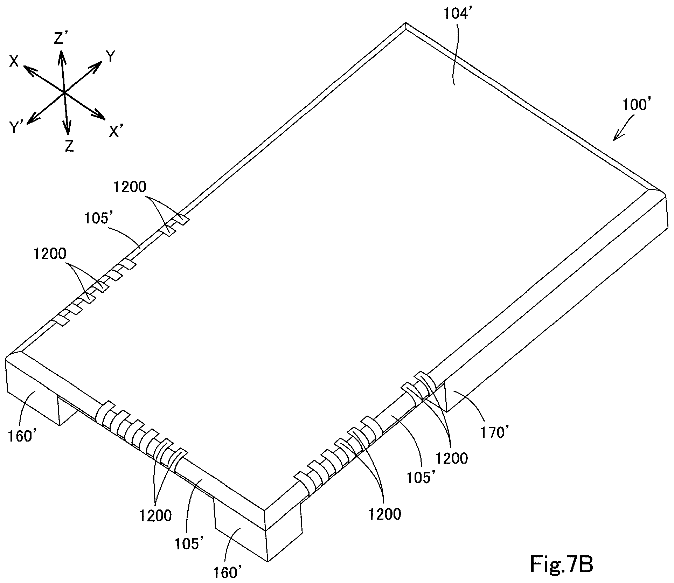

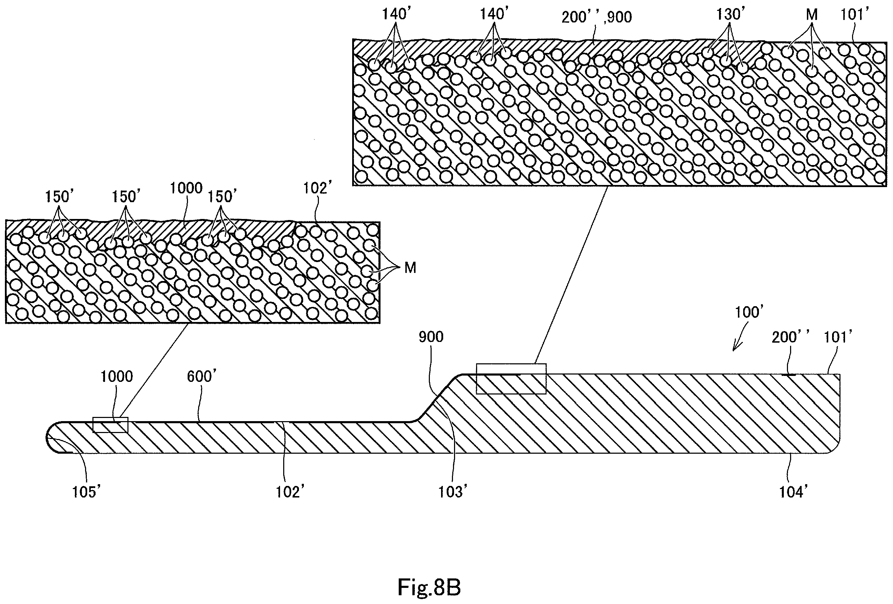

The following describes a contactless communication module M5 (also referred to hereinafter as a module M5) according to a tenth embodiment of the invention with reference to Figs. 7A to 9B. Figs. 7A to 8A also indicate the Z-Z', Y-Y', and X-X' directions in a similar manner to Fig. 1A. Figs. 8B to 9B indicate the Z-Z' and Y-Y' directions.

The module M5 includes a base 100', at least one antenna 200", at least one semiconductor component 300, at least one internal connection 900, and at least one external connection 1000.

The base 100' is a solid block of an insulating resin. The base 100' includes a first outer face 101'. The first outer face 101' is the entire region or a partial region (hereinafter referred to as a first region) of the Z-direction-side face of the base 100' (see Figs. 7A to 8B) and is located at the first height position in the Z-Z' direction. The first outer face 101' includes a communication area. A partner communication device can be disposed at a short distance from, and on the Z-direction side relative to, the communication area of the base 100'.

The base 100' may further include a second outer face 102'. The second outer face 102' may be any outer face located at the second height position of the base 100'. The second height position is located on the Z'-direction side relative to the first height position.

The second outer face 102' may serve as a second region, which is different from the first region of the Z-direction-side face of the base 100'. In this case, the base 100' may preferably further include a thick portion 110' and a thin portion 120'. The thick portion 110' may be provided at any position of the base 100'. For example, the thick portion 110' may be an end portion on the Y-direction side of the base 100' as shown in Figs. 7A to 8B, or alternatively the thick portion 110' may be an intermediate portion in the Y-Y' direction of the base 100'. The Z-direction-side face of the thick portion 110' may serve as the first outer face 101'. The thick portion 110' has such a dimension in the Z-Z' direction that the first outer face 101' is located at the first height position in the Z-Z' direction. The thin portion 120' may be provided at any portion that is different from the thick portion 110' of the base 100'. The Z direction-side face of the thin portion 120' may serve as the second outer face 102'. The thin portion 120' has a dimension in the Z-Z' direction that is smaller than that of the thick portion 110' such that the second outer face 102' is located at the second height position in the Z-Z' direction.

The thin portion 120' may be provided on the base 100' so as to be located next to the thick portion 110'. For example, if the thick portion 110' is the end portion on the Y-direction side of the base 100', the thin portion 120' may be an end portion on the Y'-direction side of the base 100' as shown in Figs. 7A to 8B, or may be an intermediate portion in the Y-Y' direction of the base 100'. If the thick portion 110' is the intermediate portion of the base 100', the thin portion 120' may be an end portion on the Y- or Y'-direction side of the base 100'.

The base 100' may further include a third outer face 103'. The third outer face 103' may serve as a third region, which is different from the first and second regions of the Z-direction-side face of the base 100'. The third outer face 103' extends obliquely or orthogonally from the first outer face 101' to the second outer face 102'. The third outer face 103' may be a flat face, an arc-shaped face, or a face with projections and depressions. In Figs. 7A to 8B, the third outer face 103' is a flat face obliquely extending from the first outer face 101' to the second outer face 102'.

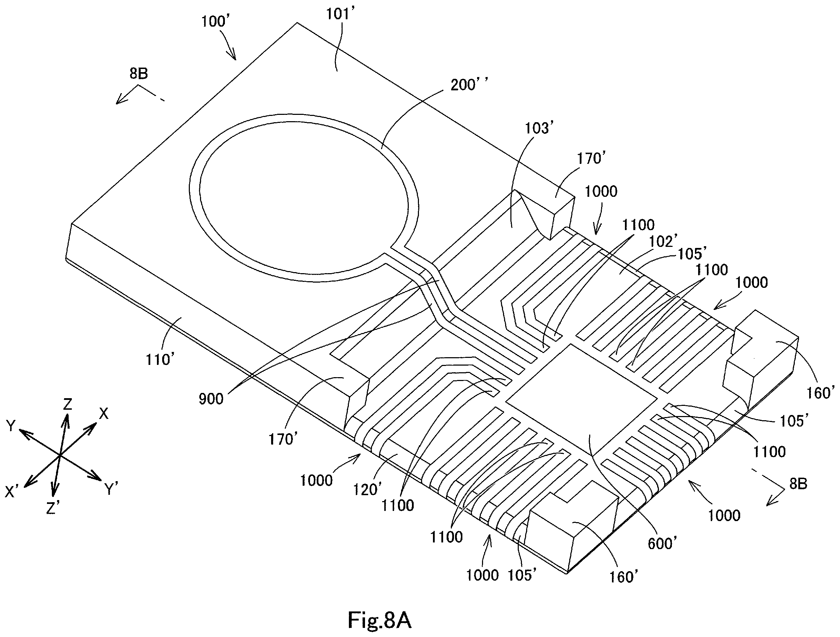

The base 100' may further include a fourth outer face 104'. The fourth outer face 104' may be at least a partial region of the Z'-direction-side face (back face) of the base 100'. The fourth outer face 104' may be, but is not limited to, e.g. a mounting face mountable on a circuit board or other part of an electronic device (not shown) or a fixing face fixable to a frame or other part of the electronic device. The base 100' may further include at least one fifth outer face 105'. The or each fifth outer face 105' may preferably a side face of the base 100' extending from at least one of the first outer face 101' and the second outer face 102' to the fourth outer face 104'. The fifth outer face 105' may be a flat face, an arc-shaped face, or a face with projections and depressions. In Figs. 7A to 8B, a plurality of fifth outer faces 105' of arc-shape is provided, extending from the second outer face 102' to the fourth outer face 104'.

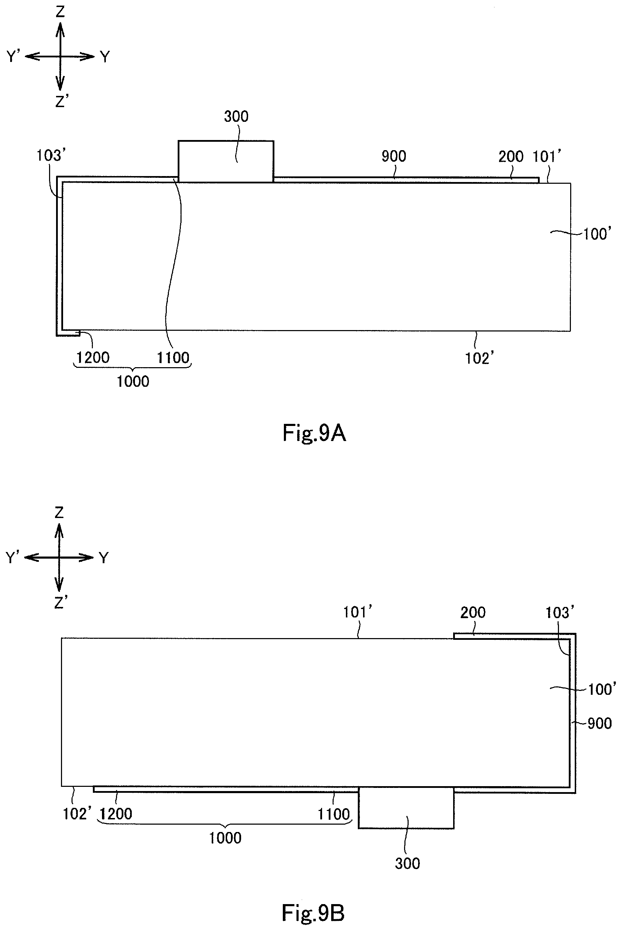

In the base 100' of another aspect, as shown in Figs. 9A and 9B, the second outer face 102' may be at least a partial region of the Z'-direction-side face (back face) of the base 100'. In this case, the second outer face 102' may be, but is not limited to, e.g. a mounting face mountable on a circuit board or other part of an electronic device (not shown) or a fixing face fixable to a frame or other part of the electronic device. In this case, the third outer face 103' may preferably be, for example, a side face of the base 100' or a wall with a hole or cutout (not shown) in the base 100', and may extend from the first outer face 101' to the second outer face 102'. The third outer face 103' may also be a flat face, an arc-shaped face, or a face with projections and depressions. The base 100' of this aspect may also include a thick portion and a thin portion.

It is possible to omit the second outer face 102', the third outer face 103', the fourth outer face 104', the fifth outer face 105', the thick portion 110' and/or the thin portion 120' described above.

The at least one antenna 200" is provided on the first outer face 101' of the base 100' such as to be able perform contactless communication with the partner communication device, and is located at the first height position. The antenna 200" may adapted for communication with a partner communication device by substantially the same communication schemes as the schemes for the antenna 200 of the module M1.

The at least one antenna 200" may be constituted by a metal plate, a coil, a conductor, or the like.

Alternatively, the at least one antenna 200" may be a metal film formed on the first outer face 101' of the base 100' of any of the above aspects described above. Such antenna 200" may be formed on the first outer face 101' by drawing with a printing machine, such as an inkjet printing machine. Alternatively, such antenna 200" may be formed on the first outer face 101' by sputtering, electroless plating, or evaporation, followed by removal of the unnecessary part of the metal film (the part other than the antenna 200") by laser or chemical etching.

Alternatively, the at least one antenna 200" may be a plated film (metal film) formed on first plating catalysts 130' on the first outer face 101' of the base 100' of any of the above aspects. The first plating catalysts 130' are formed on the first outer face 101' of the base 100', in a shape conforming to the antenna 200". In this case, metal complexes M are dispersed in the base 100' as shown in Fig. 8B. Part of the metal complexes M on the first outer face 101', i.e. the metal complexes M corresponding to the shape of the antenna 200", are activated by a laser. The activated metal complexes M serve the first plating catalysts 130'. On top of the first plating catalysts 130', the antenna 200" is formed by electroless plating. For the convenience of illustration, the metal complexes M are exaggerated in size in Fig. 8B. The metal complexes are not shown in Figs. 9A and 9B. Also, the first plating catalysts 130' and the antenna 200" may be formed by a known method for producing molded interconnect devices (MIDs).

It is possible to modify the shape of the antenna 200" as appropriate according to the communication scheme adopted. In Figs. 7A to 8B, the antenna 200" has a loop shape. A plurality of the antennas 200" may be provided. In this case, all the antennas 200" may be receiving antennas or transmitting antennas, or alternatively at least one of the antennas 200" may be a receiving antenna or antennas and the remainder is a transmitting antenna or antennas.

The at least one semiconductor component 300 may have substantially the same configuration to that of the semiconductor component 300 of the first embodiment. The semiconductor component 300 is mounted on the first outer face 101' or the second outer face 102' of the base 100' of any of the above aspects. For example, if the at least one semiconductor component 300 is mounted on the second outer face 102', the antenna 200" on the first outer face 101' may be located on the Z-direction side relative to the end face on the Z-direction side of the semiconductor component 300 on the second outer face 102'. In this case, the first outer face 101' may preferably be located on the Z-direction side relative to the end face on the Z-direction side of the semiconductor component 300 on the second outer face 102'.

The at least one internal connection 900 may have any configuration adapted to electrically connect the antenna 200" to the semiconductor component 300.

The at least one internal connection 900 may be constituted by a terminal, a pin, a lead wire, a cable, or the like. In this case, the at least one internal connection 900 may be provided on, inside, or outside the base 100' of any of the above aspects.

Alternatively, the at least one internal connection 900 may be a metal film formed on the base 100' of any of the above aspects. In this case, the at least one internal connection 900 may be configured as described below, in cases A) to C) described below.

A) The antenna 200" and the semiconductor component 300 are provided on the first outer face 101' of the base 100' (see Fig. 9A). B) The antenna 200" is provided on the first outer face 101' of the base 100', and the semiconductor component 300 is provided on the second outer face 102', which is the second region of the Z-direction-side face of the base 100' (Figs. 7A to 8B). C) The antenna 200" is provided on the first outer face 101' of the base 100', and the semiconductor component 300 is provided on the second outer face 102', which is at least the partial region of the Z'-direction-side face of the base 100' (See Fig. 9B).

In case A), the internal connection 900 may preferably be formed on the first outer face 101'. In case B) or C), one of the following configurations a) or b) is adopted. a) The internal connection 900 is formed on the second outer face 102' and the third outer face 103'. b) The internal connection 900 is formed on the first outer face 101', the second outer face 102', and the third outer face 103'.

The internal connection 900, being a metal film, formed on one or more of the outer faces of the base 100', by the same method as that for the antenna 200" being a metal film. The internal connection 900 may be continuous with the antenna 200" if being a metal film, or may be connected to the antenna 200" if made of a material other than a metal film. In the former case, the antenna 200" and the at least one internal connection 900 are constituted by a single metal film.

Alternatively, the at least one internal connection 900 may be a plated film (metal film) formed on second plating catalysts 140' of an outer face of the base 100'. The at least one internal connection 900 and the second plating catalysts 140' may be configured as follows in cases A) to C) described above.

In case A), the second plating catalysts 140' are formed on the first outer face 101' in a shape conforming to the internal connection 900, and the internal connection 900 is formed on the second plating catalysts 140' on the first outer face 101". In case B) or C), one of the following configurations c) or d) is adopted. c) The second plating catalysts 140' are formed on the second outer face 102' and the third outer face 103' in accordance with the shape of the internal connection 900, and the internal connection 900 is formed on the second plating catalysts 140' of the second outer face 102' and the third outer face 103'. d) The second plating catalysts 140' are formed on the first outer face 101', the second outer face 102', and the third outer face 103' in accordance with the shape of the internal connection 900, and the internal connection 900 is formed on the second plating catalysts 140' of the first outer face 101', the second outer face 102', and the third outer face 103'. In any case, it is preferable that the second plating catalysts 140' be continuous with the first plating catalysts 130', and that the internal connection 900 be continuous with the antenna 200". In other words, it is preferable that the first plating catalysts 130' and the second plating catalysts 140' be formed as one set of plating catalysts, and the antenna 200", and that the internal connection 900 be formed by one plated film. The internal connection 900, being a plated film, may be connected to the antenna 200" if made of a material other than a plated film. The second plating catalysts 140' are formed on one or more of the outer faces of the base 1 00' by the same method as that for the first plating catalysts 130', and the internal connection 900 being a plated film or films, is formed on the second plating catalysts 140' by the same method as that for the antenna 200" being a plated film.

The internal connection 900 of any of the above aspects includes a first portion and a second portion. The first portion of the internal connection 900 is connected to, or continuous with, the antenna 200". The second portion of the internal connection 900 is connected to the first connection portion of the semiconductor component 300. In the internal connection 900 of any of the above aspects may optionally be routed to an outer face of the base 100' as long as the first portion is connected to, or continuous with, the antenna 200" while the second portion is connected to the first connection portion of the semiconductor component 300. The second plating catalysts 140' may optionally be formed on an outer face of the base 100' in accordance with the shape of the internal connection 900.

The internal connection 900 of any of the above aspects may extend in a direction including a component of the orthogonal direction such that the antenna 200" is located away from the semiconductor component 300 in a direction including the component of the orthogonal direction. In this case, the antenna 200" is not disposed on the Z-direction side relative to the semiconductor component 300, but disposed away from the semiconductor component 300 in a direction including a component of the orthogonal direction, or disposed at a distance from the semiconductor component 300 in the orthogonal direction. The orthogonal direction may be any direction orthogonal to the Z-Z' direction, which may be the Y-Y' direction, the X-X' direction, or a direction other than the Y-Y' and X-X' directions.

The internal connections 900 of any of the above aspects may be provided as a plurality of the internal connections 900 similarly to the internal connections 400. The second plating catalysts 140' may be provided as a plurality of sets of the second plating catalysts 140', in accordance with the number of the internal connections 900. In Figs. 7A to 8B, a pair of internal connections 900 is provided as plated films, which are formed such as to be continuous with first and second ends, respectively, of the loop-shaped antenna 200". Also, the second plating catalysts 140' are provided in two sets, which sets are continuous with first and second ends, respectively, of the set of the first plating catalysts 130'. In short, the pair of internal connections 900 connects the single loop-shaped antenna 200" and the single semiconductor component 300.

The at least one external connection 1000 is only required to be connected to the semiconductor component 300 and connectable to an external device. The at least one external connection 1000 includes a first portion 1100 and a second portion 1200. The first portion 1100 is connected to a second connection portion of the semiconductor component 300. The second portion 1200 is connectable to a circuit board or other part of the electronic device located outside the base 100'.

The at least one external connection 1000 may be constituted by a terminal, a pin, a lead wire, a cable, a conductive wire, or the like. In this case, the or each external connection 1000 may be provided on, inside, or outside the base 100' of any of the above aspects.

Alternatively, the at least one external connection 1000 may be a metal film. In this case, the at least one external connection 1000 may have any of the following configurations in cases A) to C) described above.

In case A), one of the following configurations e) or f) is adopted. e) The external connection 1000 may preferably be formed on the first outer face 101'. In this case, the first portion 1100 is located on the first outer face 101'. The second portion 1200 is located on the first outer face 101' and exposed to the outside of the base 100'. f) The external connection 1000 may preferably be formed on the first outer face 101' (front face of the base 100'), the second outer face 102' (back face of the base 100'), and the third outer face 103" (side face of the base 100') as shown in Fig. 9A. In this case, the first portion 1100 is located on the first outer face 101'. The second portion 1200 is located on the second outer face 102' and exposed to the outside of the base 100'.

In case B), one of the following configurations g) or h) is adopted. g) The external connection 1000 may preferably be formed on the second outer face 102'. In this case, the first portion 1100 is located on the second outer face 102'. The second portion 1200 is located on the second outer face 102' and exposed to the outside of the base 100'. h) The external connection 1000 may preferably be formed on the second outer face 102' (a part of the front face of the base 100'), the fourth outer face 104' (back face of the base 100'), and the fifth outer face 105' (the side face of the base 100') as shown in Figs. 7A to 8A. In this case, the first portion 1100 is located on the second outer face 102'. The second portion 1200 is located on the fourth outer face 104' and exposed to the outside of the base 100'.

In case C), the external connection 1000 may preferably be formed on the second outer face 102'. In this case, the first portion 1100 is located on the second outer face 102'. The second portion 1200 is located on the second outer face 102' and exposed to the outside of the base 100'.

The external connection 1000 described above is formed on one or more of the outer faces of the base 100' by the same method as that for the antenna 200" if being a metal film.

Alternatively, the at least one external connection 1000 may be provided as a plated film or films (metal film or films) formed on third plating catalysts 150' of an outer face of the base 100'. The at least one external connection 1000 and the third plating catalysts 150' may be configured as follows in cases A) to C) described above.

In case A), one of the following configurations i) or j) is adopted. i) The third plating catalysts 150' are formed on the first outer face 101' in accordance with the shape of the external connection 1000. The external connection 1000 has the same configuration as that of e), except that the external connection 1000 is formed on the third plating catalysts 150' of the first outer face 101'. j) The third plating catalysts 150' are formed on the first outer face 101' (front face of the base 100'), the second outer face 102' (back face of the base 100'), and the third outer face 103' (side face of the base 100') in accordance with the shape of the external connection 1000. The external connection 1000 has the same configuration as that of the f), except that the external connection 1000 is formed on the third plating catalysts 150' of the first outer face 101', the second outer face 102', and the third outer face 103'.

In case B), one of the following configurations k) or 1) is adopted. k) The third plating catalysts 150' are formed on the second outer face 102' in accordance with the shape of the external connection 1000. The external connection 1000 has the same configuration as that of g), except that the external connection 1000 is formed on the third plating catalysts 150' of the second outer face 102'. 1) The third plating catalysts 150' are formed on the second outer face 102' (a part of the front face of the base 100'), the fourth outer face 104' (back face of the base 100'), and the fifth outer face 105' (side face of the base 100') in accordance with the shape of the external connection 1000 as shown in Figs. 7A to 8A. The external connection 1000 has the same configuration as that of h), except that the external connection 1000 is formed on the third plating catalysts 150' of the second outer face 102', the fourth outer face 104', and the fifth outer face 105'.

In case C), the third plating catalysts 150' are formed on the second outer face 102' in accordance with the shape of the external connection 1000. The external connection 1000 may be configured similarly to the external connection 1000 being a metal film in case C), except that the external connection 1000 is formed on the third plating catalysts 150' of the second outer face 102'.

The third plating catalysts 150' of any of the above aspects are formed on one or more of the outer faces of the base 100' by the same method as that for the first plating catalysts 130'. Then, the external connection 1000 being a plated film is formed on the third plating catalysts 150' by the same method as that for the antenna 200" being a plated film.

The external connection 1000 according to any of the above aspects may optionally be routed on an outer face of the base 100' as long as the first portion 1100 is connected to the second connection portion of the semiconductor component 300 and the second portion 1200 is connectable to an external device. The second portion 1200 may be provided on a side face of the base 100'. The third plating catalysts 150' may optionally be formed on the outer face of the base 100' in accordance with the shape of the external connection 1000.

The external connections 1000 of any of the above aspects may be provided as a plurality of the external connections 1000 similarly to the external connections 500. The external connections 1000 may include an external connection or connections for signal transmission, for ground, and/or for a resister. The third plating catalysts 150' may be provided as a plurality of sets of the third plating catalysts 150', in accordance with the number of the external connections 1000.

In Figs. 7A to 7B, the plurality of external connections 1000 are formed on the second outer face 102', the fourth outer face 104', and the fifth outer face 105' of the base 100'. The first portions 1100 of the external connections 1000 are located on the second outer face 102' and connected to the respective second connection portions of the single semiconductor component 300. The second portions 1200 of the external connections 1000 are located on the fourth outer face 104' and exposed to the outside of the base 100'.

The base 100' of any of the above aspects may further include at least one second protector 160'. The at least one second protector 160' is a wall extending in the Z-Z' direction from the second outer face 102' of the base 100' of any of the above aspects and is disposed around the semiconductor component 300 on the second outer face 102'. The or each second protector 160' may preferably be larger in Z-Z' direction dimension than the dimension the semiconductor component 300 on the second outer face 102'. However, the or each second protector 160' may be substantially equal in Z-Z' direction dimension to, or smaller in Z-Z' direction than, the semiconductor component 300 on the second outer face 102'. The or each second protector 160' protects the semiconductor component 300. In Figs. 7A to 8A, two second protectors 160' are provided, extending in the Z-Z' direction from the second outer face 102'. In Figs. 9A to 9B, the second protector 160' are not shown. The second protector 160' may be omitted.

If the Z-direction-side face of the base 100' includes the first outer face 101', the second outer face 102', and the third outer face 103', the base 100' may further include at least one third protector 170'. The at least one third protector 170' is a wall extending from the third outer face 103' along the second outer face 102' of the base 100' and is disposed around the semiconductor component 300 on the second outer face 102'. The or each third protector 170' may be integral with the second outer face 102', or extend such as to be in contact with the second outer face 102', or be disposed in spaced relation to the second outer face 102' in the Z-Z' direction. The height position of the end face on the Z-direction side of the or each third protector 170' may preferably be located on the Z-direction side relative to the height position of the end face on the Z-direction side of the semiconductor component 300 on the second outer face 102'. Alternatively, the height position of the end face on the Z-direction side of the or each third protector 170' may be located at the same height position as, or on the Z'-direction side relative to, the end face on the Z-direction side of the semiconductor component 300 on the second outer face 102'. The or each third protector 170' protects the semiconductor component 300. In Figs. 7A to 8A, two third protectors 170' are provided, extending from the third outer face 103' along the second outer face 102'. The third protector 170' may be omitted.

The module M5 may further include at least one island 600'. The at least one island 600' may preferably be provided on the first outer face 101' or the second outer face 102' of the base 100' of any of the above aspects. The at least one island 600' may be constituted by a metal plate, or a metal film (including a plated film), similarly to the antenna 200". Mounted on the island 600' is the semiconductor component 300. The island 600' may be omitted.

The module M5 may further include the first conductor S, similarly to the module M1.

The module M5 described above has the following technical features. First, the module M5 has the same features as the first and second technical features of the module M1.

Second, the module M5 offers improved versatility. This is because applications (i.e. for reception or transmission) and/or capabilities (i.e. communication speed and/or communication range) of the module M5 can be changed simply by selecting a semiconductor component 300 suitable for the application, the capabilities, etc. of the module M5, mounting the semiconductor component 300 on the first outer face 101' or the second outer face 102' of the base 100', and connecting the semiconductor component 300 to the internal connection(s) 900 and the external connection(s) 1000.

Third, it is easy to arrange the antenna 200" and the semiconductor component 300 on the first outer face 101' (at the first height position) and the second outer face 102' (at the second height position), respectively, for the following reason. The antenna 200" is provided on the first outer face 101'. The semiconductor component 300 can be disposed at the second height position simply by mounting the semiconductor component 300 on the second outer face 102'.

Fourth, if the antenna 200", the internal connection(s) 900, and the external connection(s) 1000 are constituted by a single metal plate formed on the base 100', the module M5 has a decreased number of components.

Fifth, if constituted by a single metal plate formed on the base 100', the antenna 200", the internal connection 900(s), and the external connection(s) 1000 are can be patterned freely on the base 100'.

Sixth, if the antenna and/or the internal connection(s) are constituted by a metal plate, a mold is required for forming the antenna and/or the internal connection(s). However, if the antenna 200", the internal connection(s) 900, and the external connection(s) 1000 are a metal film on the base 100', they can be fabricated without a mold. Therefore, it is possible to pursue cost reduction of the module M5.

The contactless communication modules described above are not limited to the above embodiments but may be modified in any manner within the scope of the claims.

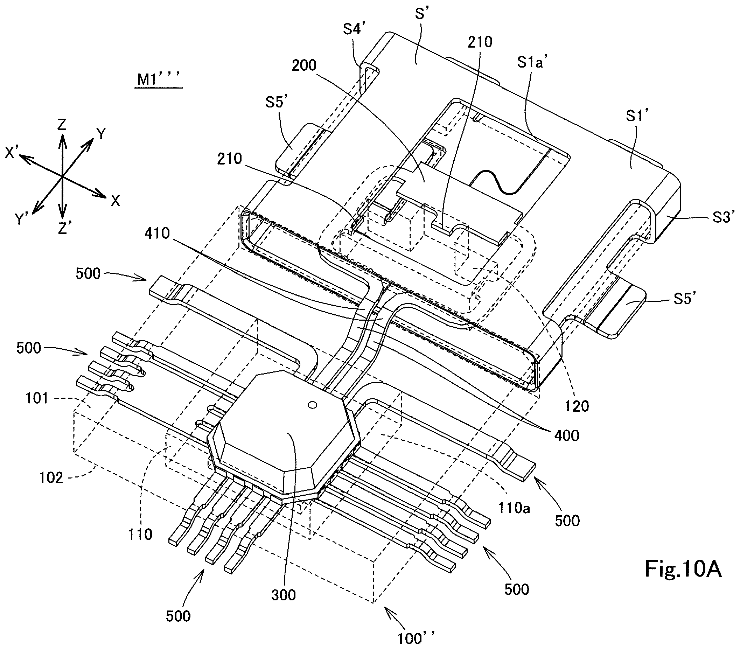

The contactless communication module according to any of the above aspects may further include a second conductor. The second conductor is constituted by a metal plate, a plate of plastic material having an outer face covered with evaporated metal, or the like. The second conductor is grounded and disposed on the Z-direction side relative to the antenna 200, 200', or 200", i.e. between the antenna 200, 200', or 200" and the antenna of a partner communication device. More specifically, the second conductor is provided on the first outer face 101 or 101' of the base 100 or 100' or inside the base 100 such as to be located on the Z-direction side relative to the antenna 200, 200', or 200". The second conductor has an opening, which is located on the Z-direction side relative to at least a part of the antenna 200, 200', or 200". If the antenna 200, 200', or 200" of any of the above aspects is adapted to transmit signals by an electromagnetic field coupling scheme, an electromagnetic field radiated from the antenna 200, 200', or 200" spreads toward the grounded second conductor. As the second conductor has the opening as described above, the electromagnetic field flowing from the antenna 200, 200', or 200" to the second conductor propagates easily through the opening to the antenna of the partner communication device located on the Z-direction side relative to the antenna 200, 200', or 200". It is thus possible to flow the electromagnetic field radiated from the antenna 200, 200', or 200" in a desired direction (in the direction toward the antenna of the partner communication device). If the antenna of any of the above aspects is adapted to receive signals by an electromagnetic field coupling scheme, an electromagnetic field outputted from the antenna of the partner communication device spreads toward the grounded second conductor. As the second conductor has the opening as described above, the electromagnetic field flowing from the antenna of the partner communication device propagates easily through the opening to the antenna 200, 200', or 200". It is thus possible to flow the electromagnetic field outputted from the antenna of the partner communication device in a desired direction (in the direction toward the antenna 200, 200', or 200"). If a part (antenna body) of the antenna is larger in outer size than other parts (see Fig. 10A), the opening may be provided in the second conductor such as to surround the antenna body. In other words, the opening may be larger in outer size than the antenna body, and the antenna body may be disposed inside the opening in plan position. As such, the electromagnetic field radiated from the antenna body propagates easily through the opening to the antenna of the partner communication device, and the electromagnetic field outputted from the antenna of the partner communication device propagates easily through the opening to the antenna body. The configurations of the second conductor described above is not limited to the case where an electromagnetic field coupling scheme is adopted for the antenna 200, 200', or 200", but applicable to the case where electromagnetic waves other than electromagnetic fields are radiated from the antenna 200, 200', or 200".

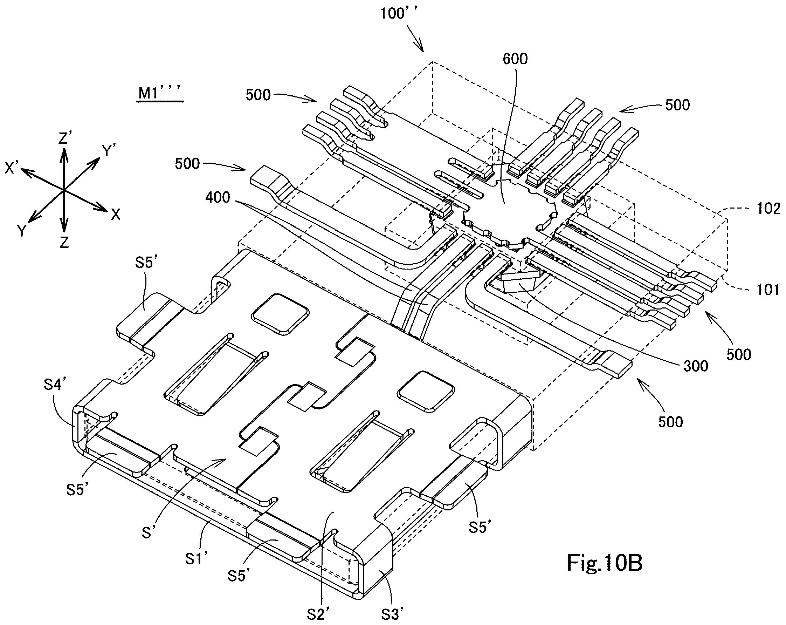

The contactless communication module M1 may be configured to include a metal case S' in place of the first conductor S. As an example of such configuration, a contactless communication module M1"' is shown in Figs. 10A and 10B. The contactless communication module M1"' has substantially the same configuration as that of the contactless communication module M1, except that the first conductor S is replaced with the metal case S'. The metal case S' of the contactless communication module M1"' receives at least the portion of the base 100 in which the antenna 200 is embedded. This means that the metal case S' surrounds the antenna 200. The metal case S' includes a first plate S1', a second plate S2', a third plate S3', and a fourth plate S4'. The third plate S3' couples the X-direction end of the first plate S1' with the X-direction end of the second plate S2'. The fourth plate S4' couples the X'-direction end of the first plate S1' with the X'-direction end of the second plate S2'. The third plate S3' and the fourth plate S4' may or may not be each provided with a cutout. The first plate S1' is disposed on the first outer face 101 of the base 100" such as to be located on the Z-direction side relative to at least the part of the antenna 200. The first plate S1' functions as the second conductor described above. The first plate S1' has an opening S1a'. The opening S1a' of the first plate S1' is provided on the Z-direction side relative to at least the part of the antenna 200. In Fig. 10A, the opening S1a' is disposed on the Z-direction side relative to the substantially rectangular antenna body of the antenna 200. This means that the antenna body is located inside the opening S1a' when viewed from the Z-direction side. The second plate S2' is disposed on the second outer face 102 of the base 100" such as to be located on the Z'-direction side relative to at least the part of the antenna 200. The second plate S2' functions as the first conductor described above.

The metal case S' may further include a connection portion S5'. The connection portion S5' may be connected to a ground line of the circuit board of the electronic device. A through-hole 120 may be made in the base 100" of the contactless communication module M1"'. The through-hole 120 extends in the Z-Z' direction through a portion of the base 100" inside the antenna 200. The through-hole 120 may have any shape. In Fig. 10A, the through hole 120 has a T-shape. A plurality of tabs 210 extend from the antenna 200, each protruding from a wall of the through-hole 120 into the through-hole 120. In Fig. 10A, the tabs 210 protrudes from the respective walls on the X-, X'-, and Y- direction sides of the through-hole 120. The tabs 210 are coupled to a coupling member before the antenna 200 is insert-molded in the base 100. After the insert molding, the tabs 210 and the coupling member are disposed inside the through-hole 120 of the base 100. Subsequently, the tabs 210 are cut off from the coupling member and remain in a state in which the tabs 210 protrude into the through-hole 120. It should be appreciated that any of the contactless communication modules described above other than the contactless communication module M1 may also include the metal case S' in place of the first conductor S. Also, any of the contactless communication modules described above other than the contactless communication module M1"' may have the through hole 120 and include the a antenna 200 with the tabs 210 protruding from the through-hole 120. The metal case S' may be provided in any of the modules other than the contactless communication module M1"'. If the metal case S' is provided in the module M5, it is preferable that the metal case S' be out of contact with the antenna 200", the internal connection(s) 900, and/or the external connection(s) 1000, by intervening an insulator therebetween.

The internal connection(s) of the contactless communication module M1' or M1" may be constituted by the entirety of, or a part of, a flexible circuit board or a rigid flexible circuit board (first circuit board). In this case, the antenna 200 is provided on the first portion of the internal connection(s). The internal connection(s) may be curved such that the antenna 200 is located at the first height position and that the semiconductor component 300 is located at the second height position. The first circuit board may include the external connection(s). The internal connection(s) of the contactless communication modules M1' or M1" may be constituted by a multilayer board having a plurality of layers laminated in the first direction. The layers may include a first layer and a second layer. The first layer may be configured such that the antenna is provided thereon such as to be located at the first height position. The second layer may be configured such that the semiconductor component is mounted thereon such as to be located at the second height position. Between the first and second layers there may or may not be provided a plurality of layers.

The antenna of the invention is not limited to antennas for contactless communication but may be applicable to antennas for contactless charging. If the antenna of the invention is an antenna for contactless charging, the semiconductor component of the invention may be a semiconductor element, a semiconductor chip, or a plastic packaged semiconductor device for causing the antenna to perform contactless power transfer (contactless power transmission or contactless power reception). The remaining configuration of the module of the invention is similar to the configuration of the modules described above.

It should be appreciated that the above embodiments and variants of the contactless communication module are described above by way of examples only. The materials, shapes, dimensions, numbers, arrangements, and other configurations of the constituents of the contactless communication module may be modified in any manner if they can perform similar functions. The configurations of the embodiments and the variants described above may be combined in any possible manner. The first direction of the invention may be freely defined. The second direction of the invention may be freely defined as long as the second direction is orthogonal to the first direction of the invention.

### Reference Signs List

M1, M1', M1", M1"': contactless communication module
   100: base
      101: first outer face
      102: second outer face
      110: accommodation hole
      200: antenna
      300: semiconductor component
      400: internal connection
      500: external connection
         510: first portion
         520: second portion
      600: island
      700: circuit board (third circuit board)
      700': circuit board (third circuit board)
         710': external connection
            711': first portion 712': second portion
      S: first conductor
      S': metal case
         S1': first plate (second conductor)
            S1a': opening
         S2': second plate (first conductor)
M2: contactless communication module
   100: base
      101: first outer face
      102: second outer face
      110: accommodation hole
      200: antenna
      300: semiconductor component
      800: circuit board (first circuit board)
         810: internal connection
            811: first portion
            812: second portion
            813: intermediate portion
      500: external connection
         510: first portion
         520: second portion
M3, M3', M3": contactless communication module
   100: base
      101: first outer face
      102: second outer face
      110: accommodation hole
      200': antenna
      300: semiconductor component
      400': internal connection
      500: external connection
         510: first portion
         520: second portion
      700: circuit board (third circuit board)
      700': circuit board (third circuit board)
         710': external connection
            711': first portion
            712': second portion
M4, M4': contactless communication module
   100: base
      101: first outer face
      102: second outer face
      110: accommodation hole
      200': antenna
      300: semiconductor component
      800": circuit board (second circuit board)
         810": internal connection
         811": first portion
            811a": Z-direction-side face (first face) of first portion
         812": second portion
            812a": mounting face (second face)
      500: external connection
         510: first portion
         520: second portion
      800"': circuit board (second circuit board)
         810"': internal connection
         811"': first portion
            811a"': Z-direction-side face (first face) of first portion
         812"': second portion
            812a"': mounting face (second face)
         820"': external connection
            821"': first portion
            822"': second portion
M5: contactless communication module
   100': base
      101': first outer face
      102': second outer face
      103': third outer face
      104': fourth outer face
      105': fifth outer face
      110': thick portion
      120': thin portion
      130': first plating catalysts
      140': second plating catalysts
      150': third plating catalysts
      160': second protector
      170': third protector
   200": antenna
   300: semiconductor component
   600': island
   900: internal connection
   1000: external connection
      1100: first portion
      1200: second portion

## Claims

1. A contactless communication module comprising:
a base made of an insulating resin, wherein a partner communication device can be disposed at a short distance from, and on one side of a first direction relative to, the base;
an antenna, the antenna being disposed at the base, at a first height position in the first direction such as to be able to contactlessly communicate with the partner communication device;
a semiconductor component for causing the antenna to conduct contactless communication, the semiconductor component being disposed at the base, at the first height position or at a second height position on the other side of the first direction relative to the first height position;
an internal connection electrically connecting the antenna and the semiconductor component; and
an external connection including:
a first portion at the base, the first portion being electrically connected to the semiconductor component, and
a second portion protruding out of the base or being exposed to an outside of the base.

2. The contactless communication module according to claim 1, wherein
the antenna is disposed at the first height position inside the base,
the semiconductor component is disposed at the first or second height position inside the base, and
the first portion of the external connection is disposed inside the base.

3. The contactless communication module according to claim 2, wherein
the internal connection is a metal plate, a lead wire, a cable, or a conductive wire connecting the antenna and the semiconductor component, is provided inside the base, and is bent or curved such that the antenna is located at the first height position inside the base and that the semiconductor component is located at the second height position inside the base.

4. The contactless communication module according to claim 2, wherein
the antenna and the internal connection are constituted by a single metal plate and provided inside the base, and
the internal connection is bent or curved such that the antenna is located at the first height position inside the base and that the semiconductor component is located at the second height position inside the base.

5. The contactless communication module according to claim 2, further comprising a first circuit board, the first circuit board being a flexible or rigid flexible circuit board including the internal connection,
wherein the internal connection is provided inside the base and includes:
a first portion provided with the antenna,
a second portion electrically connected to the semiconductor component, and
an intermediate portion between the first and second portions of the internal connection, the intermediate portion being curved such that the antenna is located at the first height position inside the base and that the semiconductor component is located at the second height position inside the base.

6. The contactless communication module according to claim 5, wherein the first circuit board further includes the external connection.

7. The contactless communication module according to claim 2, wherein
the antenna and the internal connection are constituted by a single metal plate extending in a second direction and provided inside the base, the second direction being orthogonal to the first direction, and
the semiconductor component is connected to the internal connection on the other side of the first direction relative to the internal connection.

8. The contactless communication module according to claim 2, further comprising a second circuit board extending in a second direction orthogonal to the first direction, wherein
the second circuit board includes the internal connection, the internal connection being provided inside the base,
the internal connection includes:
a first face on one side of the first direction and
a second face on the other side of the first direction,
the antenna is provided on the first face of the internal connection, and
the semiconductor component is mounted on the second face of the internal connection, or alternatively connected to the internal connection on the other side of the first direction relative to the second face of the internal connection.

9. The contactless communication module according to claim 8, wherein
the second circuit board further includes the external connection.

10. The contactless communication module according to any one of claims 2 to 5, 7, and 8, further comprising a third circuit board with the semiconductor component mounted thereon, the third circuit board being provided at least partially inside the base,
wherein the internal connection is connected to the third circuit board and connected via the third circuit board to the semiconductor component.

11. The contactless communication module according to claim 10, wherein the third circuit board includes the external connection.

12. The contactless communication module according to any one of claims 1 to 11, wherein
the base includes an accommodation hole opening to the outside of the base,
the internal connection includes a projection disposed in the accommodation hole,
the first portion of the external connection includes a projection disposed in the accommodation hole, and
the semiconductor component is accommodated in the accommodation hole, and electrically connected in the accommodation hole to the projection of the internal connection and the projection of the first portion of the external connection.

13. The contactless communication module according to claim 12, wherein
the base further includes a first protector being a wall of the accommodation hole, the first protector surrounding the semiconductor component located in the accommodation hole.

14. The contactless communication module according to claim 1, wherein
the base includes:
a first outer face located at the first height position and
a second outer face located at the second height position,
the antenna is provided on the first outer face, and
the semiconductor component is mounted on the first or second outer face.

15. The contactless communication module according to claim 14, wherein
the base further includes a third outer face extending from the first outer face to the second outer face,
the antenna is a metal film formed on the first outer face,
the internal connection is a metal film formed on at least the second and third outer faces such as to be continuous with the antenna, and
the semiconductor component is directly connected to the internal connection on the second outer face.

16. The contactless communication module according to claim 14, wherein
the base further includes a third outer face extending from the first outer face to the second outer face,
the internal connection is a metal film formed on at least the second and third outer faces such as to be connected to the antenna, and
the semiconductor component is directly connected to the internal connection on the second outer face.

17. The contactless communication module according to claim 15 or 16, wherein
the external connection is a metal film formed at least on the second outer face of the base, the first portion of the external connection is located on the second outer face, and
the semiconductor component is directly connected to the internal connection and the first portion of the external connection on the second outer face.

18. The contactless communication module according to any one of claims 14 to 17, wherein
the base further includes at least one second protector extending in the first direction from the second outer face and being disposed around the semiconductor component.

19. The contactless communication module according to any one of claims 15 to 17, wherein
the base further includes at least one third protector extending from the third outer face along the second outer face and being disposed around the semiconductor component.

20. The contactless communication module according to any one of claims 1 to 5, 7 and 8, 10, and 14 to 16, wherein the external connection is a terminal, a pin, a lead wire, or a cable.

21. The contactless communication module according to any one of claims 1 to 20, further comprising a first conductor, the first conductor being disposed on the other side of the first direction relative to the antenna.

22. The contactless communication module according to any one of claims 1 to 20, further comprising a second conductor, the second conductor being disposed on one side of the first direction relative to the antenna and grounded,
wherein the second conductor has an opening, the opening being located on one side of the first direction relative to at least a part of the antenna.
